# EUROPEAN PATENT APPLICATION

(11) **EP 4 848 942 A1**
(43) Date of publication of application: **02.12.2026**
(21) Application number: 26165349.7
(22) Date of filing: 17.03.2026
(51) Int. Cl.: H10D 84/83, H10D 30/00, H10D 30/01, H10D 84/01, B82Y 10/00, H10D 84/85

(54) **SEMICONDUCTOR DEVICE WITH MULTI-LEVEL NANOSHEET STRUCTURES**

(30) Priority: 27.05.2025 KR 20250068889
(71) Applicant: Samsung Electronics Co., Ltd., Suwon-si, Gyeonggi-do 16677 (KR)
(72) Inventor: KIM, Minju, 16677 Suwon-si, Gyeonggi-do (KR); PARK, Wooseok, 16677 Suwon-si, Gyeonggi-do (KR); CHOI, Doyoung, 16677 Suwon-si, Gyeonggi-do (KR); JIN, Heejeong, 16677 Suwon-si, Gyeonggi-do (KR); SEO, Changdeok, 16677 Suwon-si, Gyeonggi-do (KR); PARK, Jihoon, 16677 Suwon-si, Gyeonggi-do (KR); KIM, Kyungho, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate (100), an insulation partition (121) extended along a first direction (D1) crossing a surface of the substrate (100), and a plurality of sheets (NS1) spaced apart along a second direction (D2) crossing the first direction (D1) and arranged side by side along the first direction (D1) above the substrate (100). The insulation partition (121) is between the plurality of sheets (NS1). The plurality of sheets (NS1) include a top sheet (TNS1) positioned at a highest level along the first direction (D1), and an uppermost portion of the insulation partition (121) is positioned at a level lower than or equal to an uppermost portion of the top sheet in the first direction (D1).

## Description

### BACKGROUND

Recently, as the information media is rapidly popularized, the function of a semiconductor device has also rapidly developed. With respect to up-to-date semiconductor chips, a low cost for competitiveness and the high-density integration for high quality may be required. Scaling down integrated circuit devices is in progress for the high-density integration.

Meanwhile, with the rapid down-scaling of the integrated circuit devices, accuracy in the operation as well as the fast operation speed may be required to be secured for the integration circuit devices.

### SUMMARY

The present disclosure relates to a semiconductor device.

Aspects of the present disclosure may provide a semiconductor device of which integration and electrical reliability are improved.

However, the goals to be achieved by example implementations of the present disclosure are not limited to the objectives described above and other objects may be clearly understood from the following example implementations by those skilled in the art.

According to an aspect, there is provided a semiconductor device including a substrate, an insulation partition extended along a first direction crossing a surface of the substrate, and a plurality of sheets spaced apart along a second direction crossing the first direction with the insulation partition in between and arranged side by side along the first direction above the substrate, and the plurality of sheets include a top sheet positioned at a highest level along the first direction, and an uppermost portion of the insulation partition is positioned at a level lower than or equal to that of an uppermost portion of the top sheet in the first direction.

According to another aspect, there is also provided a semiconductor device including a pair of active areas protruding from a substrate in a first direction and spaced apart along a second direction crossing the first direction; a nanosheet structure comprising: a plurality of nanosheets spaced apart along the second direction and arranged side by side along the first direction from the pair of active areas, and a top nanosheet above a nanosheet positioned at a highest level along the first direction among the plurality of nanosheets; a first insulation partition between the plurality of nanosheets spaced apart along the second direction and extends along a third direction crossing the first direction and the second direction; an upper insulation partition above an uppermost surface of the insulation partition, wherein the uppermost surface of the insulation partition crosses the first direction; and a field insulation partition spaced apart from the insulation partition along the second direction, wherein a portion of the plurality of nanosheets is between the field insulation partition and the insulation partition, wherein an uppermost portion of the uppermost surface of the insulation partition along the first direction is positioned at a level lower than an uppermost portion of an uppermost surface of the top nanosheet, wherein the uppermost portion of an uppermost surface of the top nanosheet crosses the first direction.

According to still another aspect, there is also provided a semiconductor device including a pair of active areas protruding from a substrate in a first direction and spaced apart along a second direction crossing the first direction; a first nanosheet structure comprising: a plurality of first nanosheets spaced apart along the second direction and arranged side by side along the first direction from the pair of active areas; and a first top nanosheet above a first nanosheet positioned at a highest level along the first direction among the plurality of first nanosheets; a first insulation partition between the plurality of first nanosheets spaced apart along the second direction and extending along a third direction crossing the first direction and the second direction; an upper insulation partition above an uppermost surface of the insulation partition, wherein the uppermost surface of the insulation partition crosses the first direction; an insulation film interposed between the insulation partition and the upper insulation partition; a field insulation partition spaced apart from the insulation partition along the second direction, wherein a portion of the plurality of first nanosheets is between the field insulation partition and the insulation partition; a second nanosheet structure comprising a plurality of second nanosheets spaced apart from the first nanosheet structure along the second direction and arranged side by side along the first direction, wherein the field insulation partition is between the first nanosheet structure and the second nanosheet structure; a first gate line being disposed outside a periphery of a first portion of the plurality of first nanosheets, wherein the portion of the plurality of first nanosheets is at a first side of the upper insulation partition; a second gate line being disposed outside a periphery of a second portion of the plurality of first nanosheets, wherein the second portion of the plurality of first nanosheets is at a second side opposite to the first side of the upper insulation partition; and a third gate line spaced apart from the second gate line along the second direction and being disposed outside a periphery of the plurality of second nanosheets, wherein the field insulation partition is between the second gate line and the third gate line, wherein an uppermost portion of the insulation partition in the first direction is positioned at a level lower than an uppermost portion of the first top nanosheet in the first direction.

### BRIEF DESCRIPTION OF THE DRAWINGS

These and/or other aspects, features, and advantages of the invention will become apparent and more readily appreciated from the following description of example implementations, taken in conjunction with the accompanying drawings of which:
FIG. 1 is a plan layout diagram for describing a semiconductor device according to an example implementation of the present disclosure;
FIG. 2 is an example diagram illustrating a cross section taken along line A-A' of FIG. 1;
FIG. 3 is an example diagram illustrating an enlargement of a section marked "CX1" of FIG. 2;
FIG. 4 is an example diagram illustrating a cross section taken along line B-B' of FIG. 1;
FIG. 5 is an example diagram illustrating a cross section taken along line C-C' of FIG. 1;
FIG. 6A is a diagram for describing a semiconductor device according to another example implementation of the present disclosure and an example diagram corresponding to a section marked "CX1" of FIG. 2;
FIG. 6B is a diagram for describing a semiconductor device according to another example implementation of the present disclosure and an example diagram corresponding to a section marked "CX1" of FIG. 2;
FIG. 7 is a diagram for describing a semiconductor device according to another example implementation of the present disclosure and an example diagram corresponding to a cross section taken long line A-A' of FIG. 1;
FIG. 8 is an example diagram illustrating an enlargement of a section marked "CX2" of FIG. 7;
FIG. 9 is a diagram for describing a semiconductor device according to another example implementation of the present disclosure and an example diagram corresponding to a cross section taken along line A-A' of FIG. 1;
FIG. 10 is a diagram for describing a semiconductor device according to another example implementation of the present disclosure and an example diagram corresponding to a cross section taken long line A-A' of FIG. 1;
FIG. 11 is a diagram for describing a semiconductor device according to another example implementation of the present disclosure and an example diagram corresponding to a cross section taken long line A-A' of FIG. 1;
FIG. 12 is an example diagram illustrating an enlargement of a section marked "CX3" of FIG. 11;

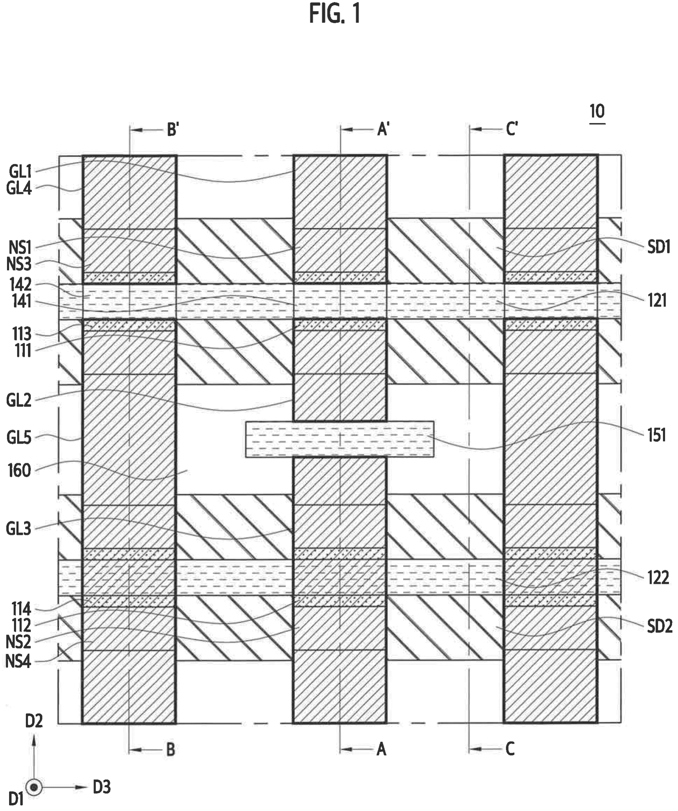

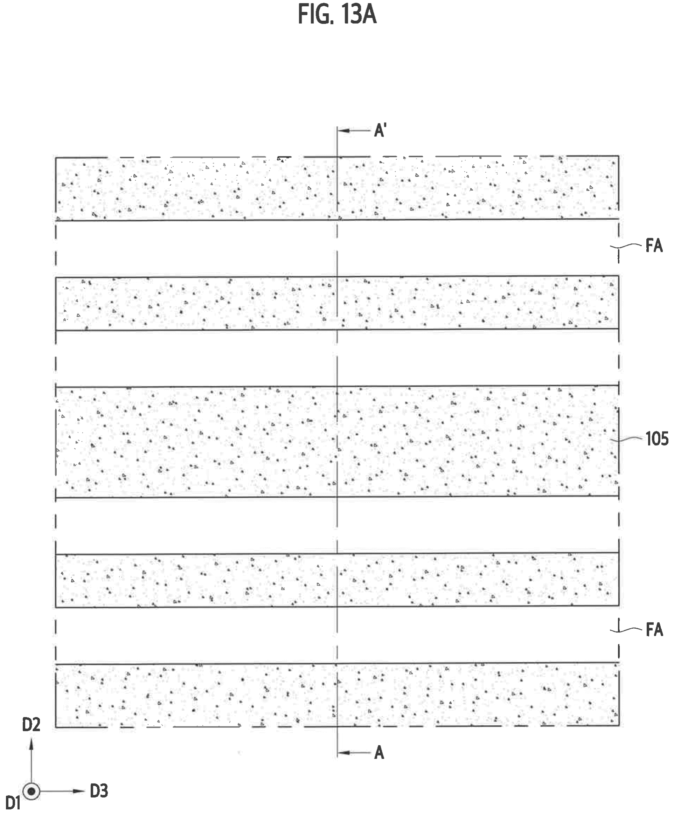

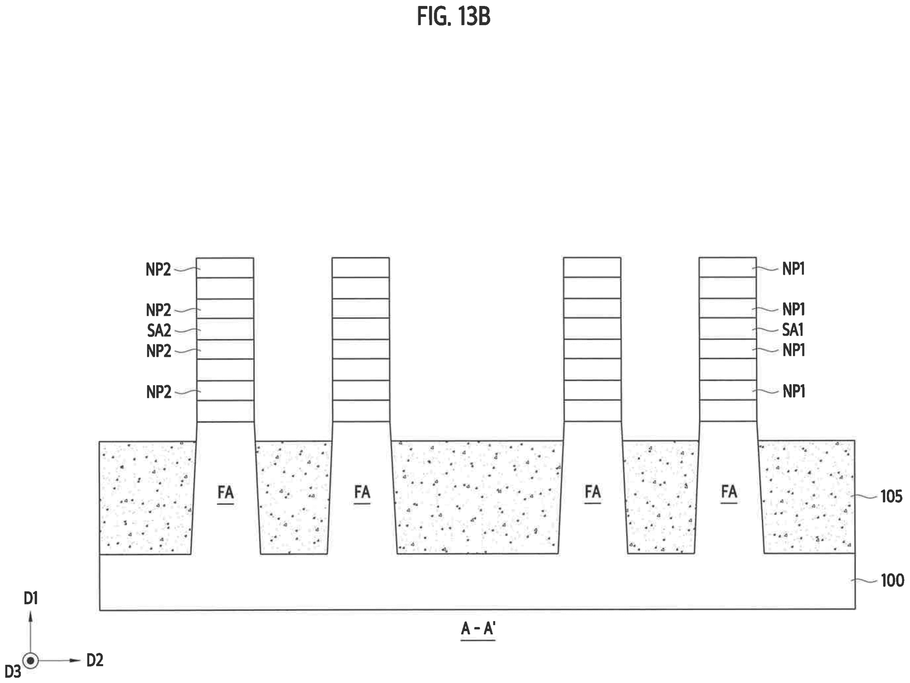

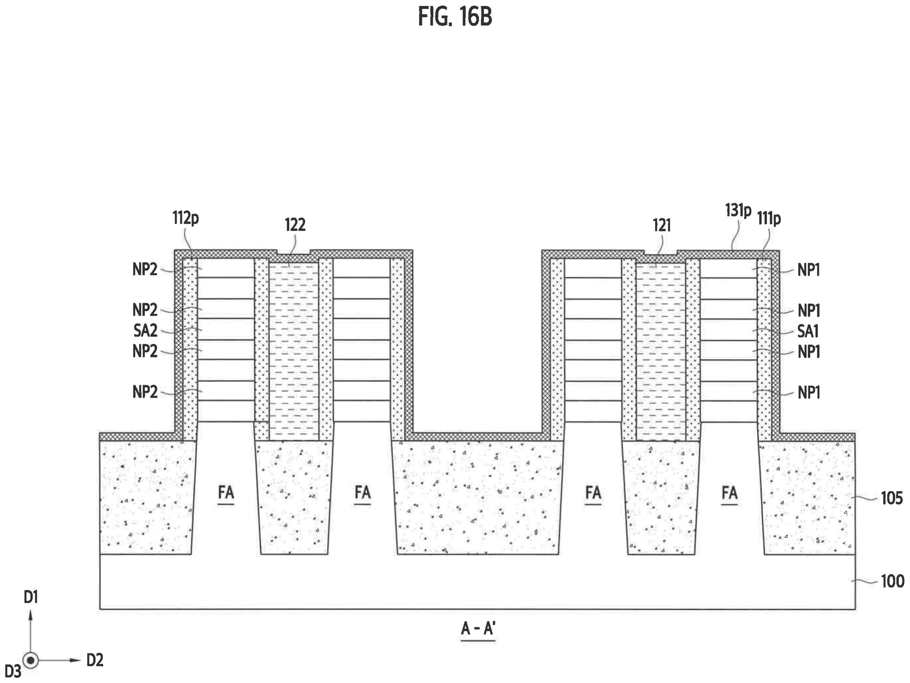

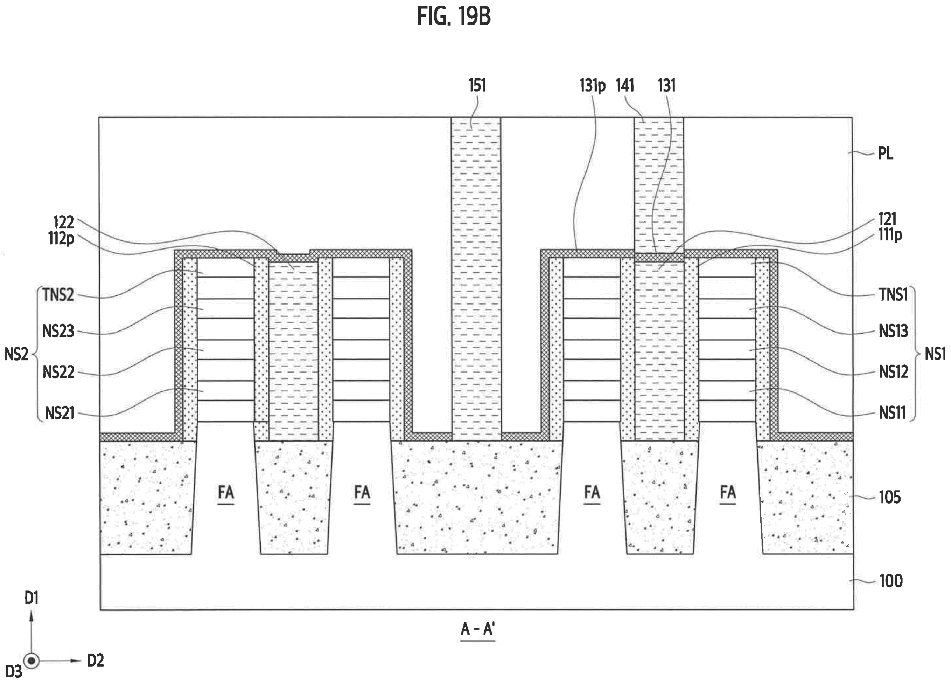

FIGS. 13A, 13B, 14A, 14B, 15A, 15B, 16A through 16C, 17A through 17C, 18A, 18B, 19A through 19C, 20A, 20B, and 21A through 21C are diagrams illustrated in process order for describing a method of manufacturing a semiconductor device according to an example implementation of the present disclosure, wherein FIGS. 13A, 14A, 15B, 16A, 17A, 18A, 19A, 20A, and 21A are layout diagrams, FIGS. 13B, 14B, 15B, 16B, 17B, 18B, 19B, 20B, and 21B are diagrams corresponding to a cross section taken along line A-A' of FIG. 1, FIGS. 17C and 21C are diagrams corresponding to a cross section taken along line C-C' of FIG. 1, and FIGS. 16C and 19C are cross-sectional diagrams for describing a method of manufacturing a semiconductor device according to another example implementation and example diagrams corresponding to FIGS. 16B and 19B.

### DETAILED DESCRIPTION

Hereinafter, the example implementations of the present disclosure will be described with reference to the accompanying drawings. the same elements in the drawings will be denoted by the same reference numerals, and redundant descriptions therefor will be omitted.

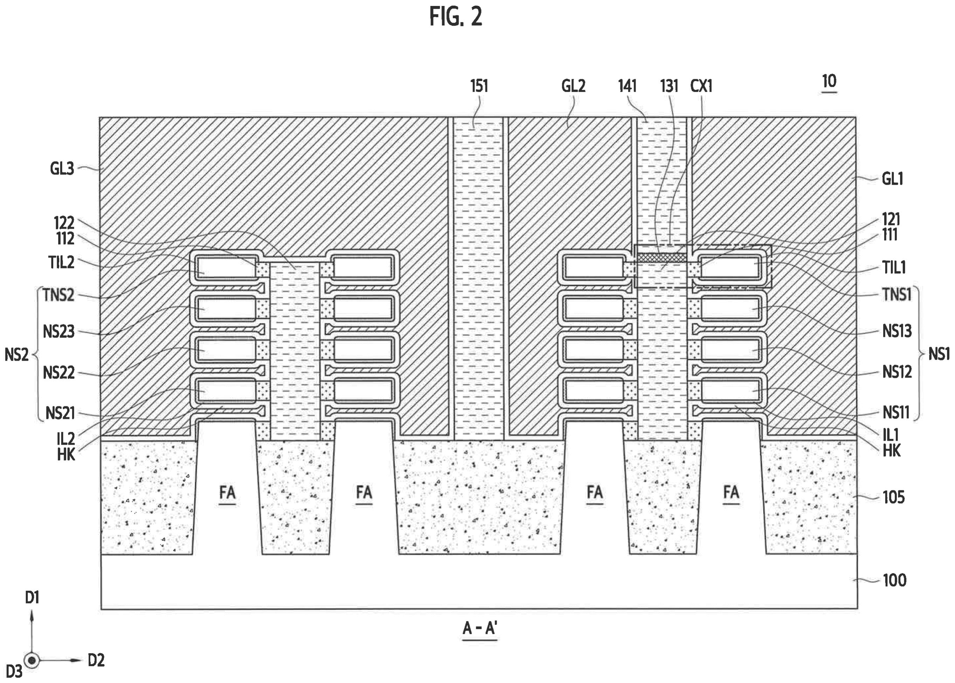

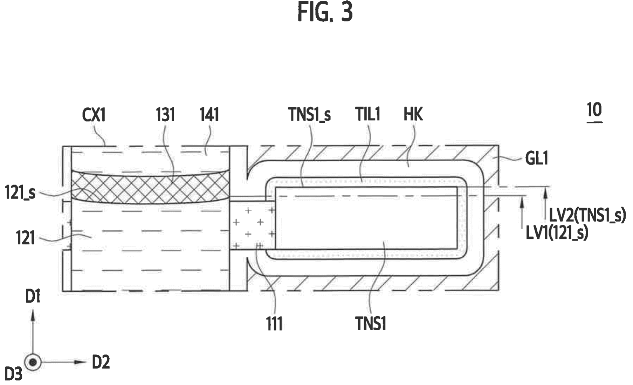

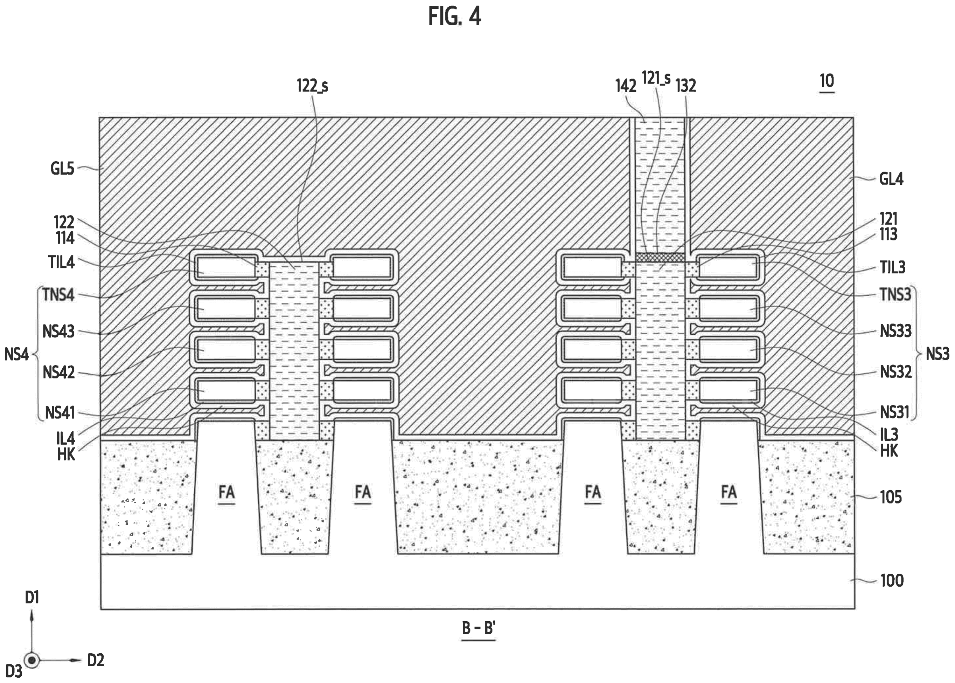

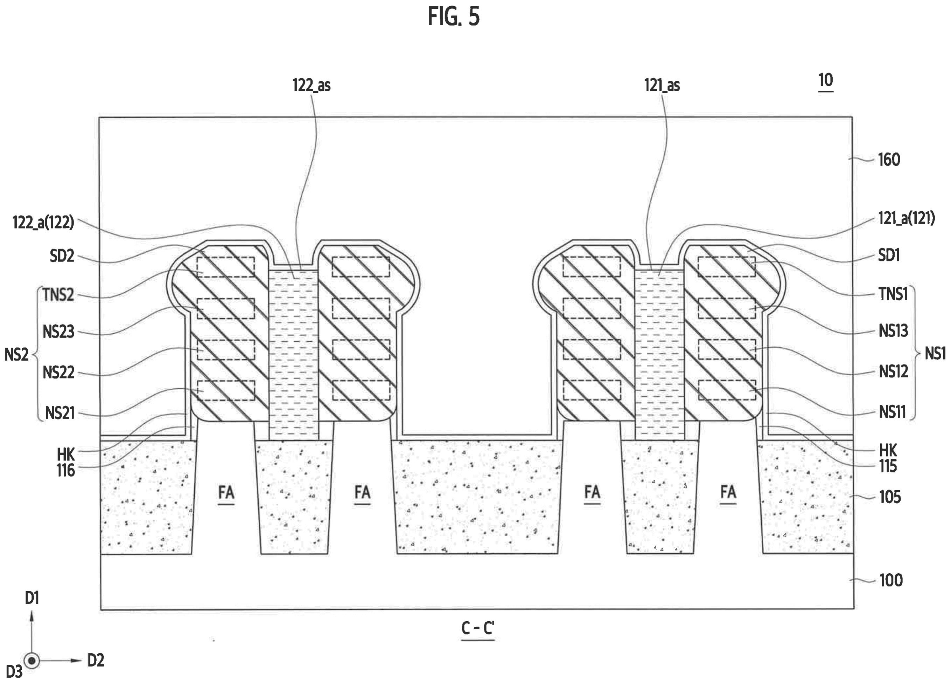

FIG. 1 is a plan layout diagram for describing a semiconductor device according to an example implementation of the present disclosure. FIG. 2 is an example diagram illustrating a cross section taken along line A-A' of FIG. 1. FIG. 3 is an example diagram illustrating an enlargement of a section marked "CX1" of FIG. 2. FIG. 4 is an example diagram illustrating a cross section taken along line B-B' of FIG. 1. FIG. 5 is an example diagram illustrating a cross section taken along line C-C' of FIG. 1.

Referring to FIGS. 1 through 5, a semiconductor device 10 according to an example implementation of the present disclosure may include a substrate 100, a device separator 105, an active area FA, first to sixth barriers 111 to 116, a first insulation partition 121, a second insulation partition 122, a field insulation partition 151, a first upper insulation partition 141, a second upper insulation partition 142, a first insulation film 131, a second insulation film 132, an inter-layer insulation film 160, first to fourth nanosheet structures NS1 to NS4, first to fifth gate lines GL1 to GL5, first to fourth interface layer IL1 to IL4, first to fourth top interface layers TIL1 to TIL4, and an insulation liner HK.

According to an example implementation, the substrate 100 may be a silicon substrate or silicon-on-insulator (SOI). Alternatively, the substrate 100 may include silicon germanium, silicon germanium on insulator (SGOI), indium antimonide, lead telluride, indium arsenide, indium phosphide, gallium arsenide, or gallium antimonide, but it is merely an example.

According to an example implementation, each of a plurality of active areas FA may protrude from the substrate 100 in a first direction D1. In the present disclosure, the first direction D1 may be defined as a direction that crosses a main surface of the substrate 100 while being a direction in which the active area FA protrudes. In the present disclosure, a second direction D2 may be defined as a direction that crosses the first direction D1 while being a direction along which a first nanosheet structure NS1 and a second nanosheet structure NS2 to be described below are spaced apart from each other. In the present disclosure, a third direction D3 may be defined as a direction that crosses the first direction D1 and the second direction D2 while being a direction along which the first insulation partition 121 and the second insulation partition 122 to be described below are extended.

According to an example implementation, each of the plurality of active areas FA may be a portion of the substrate 100 or include an epitaxial layer grown from the substrate 100. Each of the plurality of active areas FA may be extended in the third direction D3. In the present disclosure, the substrate 100 may be extended in the second direction D2 and/or the third direction D3.

According to an example implementation, the plurality of active areas FA may be sequentially spaced apart from each other side by side along the second direction D2.

According to an example implementation, the device separator 105 may be disposed on the substrate 100. The device separator 105 may cover a portion of a side wall of the active area FA. The device separator 105 may fill a space between the plurality of active areas FA spaced apart along the second direction D2 on the substrate 100.

For example, FIG. 2 illustrates that an upper surface of each of the plurality of active areas FA, which crosses the first direction D1, is formed to be higher than an upper surface of the device separator 105. However, it is merely an example. In other example implementations, the upper surface of each of the plurality of active areas FA and the upper surface of the device separator 105 may be formed substantially on an identical plane.

According to an example implementation, the device separator 105 may be formed of an oxide film. In some example implementations, the device separator 105 may be formed of an oxide film formed by a deposition process or a coating process. In some example implementations, the device separator 105 may be formed of an oxide film formed by a flowable chemical vapor deposition (FCVD) process or a spin coating process.

In the present disclosure, in order to assist in understanding the present disclosure, a side in the first direction D1 will be referred to as an upper side, and that in a reverse direction -D1 of the first direction will be referred to as a lower side. Also, a direction along the second direction D2 and/or the third direction D3 will be referred to as a side direction. A surface crossing the first direction will be referred to as an upper surface, and a surface crossing the reverse direction -D1 of the first direction will be referred to as a lower surface. A surface crossing the second direction D2 or the third direction D3 will be referred to as a side wall.

According to an example implementation, the first insulation partition 121 may be extended along the third direction D3 in a space between a pair of active areas FA adjacent to each other along the second direction D2. A lower surface of the first insulation partition 121 may be positioned to be in contact with the device separator 105 and may be extended simultaneously along the first direction D1 and the third direction D3 between the pair of active areas FA. The first insulation partition 121 may serve as a separator between a plurality of first nanosheets NS11 to NS13 spaced apart from each other along the second direction D2 and first top nanosheets TNS1 spaced apart from each other in the first nanosheet structure NS1. Exemplarily, the first nanosheet structure NS1 comprises a first stack of nanosheets (first nanosheets NS11 to NS13 and first top nanosheet TSN1), and a second stack of nanosheets (first nanosheets NS11 to NS13 and first top nanosheet TSN1). In each of the first and the second stack the nanosheets are vertically aligned along the first direction D1. The first and the second stack are separated apart from each other along the second direction D2. The second insulation partition 122 serves as a separator between the first stack and the second stack. The first insulation partition 121 may be disposed between a first gate line GL1 and a second gate line GL2, between the plurality of first nanosheets NS11 to NS13 spaced apart from each other along the second direction D2, and between a pair of first top nanosheets TNS1 spaced apart from each other. A separator described herein may be an electrical insulation film.

According to an example implementation, the second insulation partition 122 may be disposed to be spaced apart from the first insulation partition 121 along the second direction D2. Similarly to the first insulation partition 121, the second insulation partition 122 may be extended along the third direction D3 in a space between a pair of active areas FA adjacent to each other along the second direction D2. A lower surface of the second insulation partition 122 may be positioned to be in contact with the device separator 105 and may be extended simultaneously along the first direction D1 and the third direction D3 between the pair of active areas FA. The second insulation partition 122 may serve as a separator between a plurality of second nanosheets NS21 to NS23 spaced apart from each other along the second direction D2 and second top nanosheets TNS2 spaced apart from each other in the second nanosheet structure NS2. Exemplarily, the second nanosheet structure NS2 comprises a first stack of nanosheets (second nanosheets NS21 to NS23 and a second top nanosheet TSN2), and a second stack of nanosheets (second nanosheets NS21 to NS23 and a second top nanosheet TSN2). In each of the first and the second stack the nanosheets are vertically aligned along the first direction D1. The first and the second stack are separated apart from each other along the second direction D2. The second insulation partition 122 serves as a separator between the first stack and the second stack. A third gate line GL3 may be disposed to surround the second insulation partition 122. However, since not completely crossing the third gate line GL3 along the first direction D1, the second insulation partition 122 may not serve as a gate cut.

According to an example implementation, the device separator 105 may be positioned below the first insulation partition 121 and the second insulation partition 122. The device separator 105 which fills at least a portion of a gap between a pair of active areas FA positioned adjacently along the second direction D2 may be formed before the first insulation partition 121 and the second insulation partition 122 are formed. The first insulation partition 121 and the second insulation partition 122 may be formed above the device separator 105 which is formed earlier.

According to an example implementation, the first nanosheet structure NS1 and the second nanosheet structure NS2 may be disposed above the active area FA. In the present disclosure, in a cross section crossing the third direction D3, the first nanosheet structure NS1 may be positioned at a side of the field insulation partition 151, and the second nanosheet structure NS2 may be positioned at another side opposite to the side.

According to an example implementation, a whole of one of a plurality of nanosheet structures NS1 to NS4 may form a N-type field-effect transistor (NFET) or a P-type field-effect transistor (PFET). In another example implementation, among the plurality of nanosheet structures NS1 to NS4, nanosheets disposed on one side of insulation partitions 121 and 122 may form an NFET, and nanosheets disposed on the opposite side of the one side may form a PFET.

According to an example implementation, the first nanosheet structure NS1 may include the plurality of first nanosheets NS11 to NS13 and a first top nanosheet TNS1 which are sequentially disposed along the first direction D1 above the active area FA. The plurality of first nanosheets NS11 to NS13 and the first top nanosheet TNS1 all may be identical nanosheets formed to form a channel layer. In some implementations, the second nanosheet structure NS2 may include the plurality of second nanosheets NS21 to NS23 and a second top nanosheet TNS2 which are sequentially disposed along the first direction D1 above the active area FA. The plurality of second nanosheets NS21 to NS23 and the second top nanosheet TNS2 all may be identical nanosheets formed to form a channel layer.

FIG. 2 illustrates that the first nanosheet structure NS1 and the second nanosheet structure NS2 each include four nanosheets spaced apart from each other along the first direction D1. However, it is merely an example. In other example implementations, the first nanosheet structure NS1 and the second nanosheet structure NS2 each may include two, three, five, or more nanosheets spaced apart from each other along the first direction D1.

According to an example implementation, the first nanosheet structure NS1 and the second nanosheet structure NS2 may be formed of a single material. In some example implementations, the first nanosheet structure NS1 and the second nanosheet structure NS2 may be formed of a material identical to a material forming the substrate 100 or the active area FA.

According to an example implementation, the plurality of first nanosheets NS11 to NS13 may be spaced apart from each other along the second direction D2 with the first insulation partition 121 in between while being disposed to be spaced apart along the first direction D1. For example, the first nanosheet structure NS1 may have a structure in which unit nanosheets, each of which is formed with a pair of nanosheets spaced apart with the first insulation partition 121 in between, are arranged along the first direction D1.

According to an example implementation, a nanosheet positioned at a highest level along the first direction D1 in the first nanosheet structure NS1 may be defined as the first top nanosheet TNS1. Here, a height level along the first direction D1 may be a relative distance from a surface of the substrate 100 along the first direction D1. A longer distance from the surface of the substrate 100 along the first direction D1 may mean a high level. In some example implementation, two first top nanosheets TNS1 may be present. The two first top nanosheets TNS1 may be disposed to be spaced apart from each other along the second direction D2 with the first insulation partition 121 in between. Uppermost portions of uppermost surfaces of the two first top nanosheets TNS1 may have equal levels along the first direction D1. In another example implementation, one first top nanosheets TNS1 may be present. Two of the first nanosheets NS11 to NS13, which are disposed to be spaced apart from each other along the second direction D2 with the first insulation partition 121 in between, may have different levels along the first direction D1. One first nanosheet thereof, which is positioned at a higher level, may be defined as the first top nanosheet TNS1.

According to an example implementation, the plurality of second nanosheets NS21 to NS23 may be spaced apart from each other along the second direction D2 with the second insulation partition 122 in between while being disposed to be spaced apart along the first direction D1. For example, the second nanosheet structure NS2 may have a structure in which unit nanosheets, each of which is formed with a pair of nanosheets spaced apart with the second insulation partition 122 in between, are arranged along the first direction D1.

According to an example implementation, similarly to the first top nanosheet TNS1, a nanosheet positioned at a highest level along the first direction D1 in the second nanosheet structure NS2 may be defined as the second top nanosheet TNS2. In some example implementations, similarly to the first top nanosheet TNS1, the second top nanosheet TNS2 may be formed with two nanosheets having equal levels along the first direction D1. In another example implementation, similarly to the first top nanosheet TNS1, one second top nanosheet TNS2 may be present.

According to an example implementation, the first nanosheets NS11 to NS13 and the second nanosheets NS21 to NS23 may have a form of a planar sheet of which a length along the second direction D2 is longer than a length along the first direction D1. However, it is merely an example. In some example implementations, lengths of the first nanosheets NS11 to NS13 and the second nanosheets NS21 to NS23, which are along the first direction D1, may be longer than lengths along the second direction D2. The first top nanosheet TNS1 and the second top nanosheet TNS2 may be similar thereto.

According to an example implementation, a plurality of first barriers 111 may be interposed between the first insulation partition 121 and the first nanosheets NS11 to NS13 or between the first top nanosheet TNS1 and the first insulation partition 121. Side surfaces of the plurality of first barriers 111 may be in contact with the first insulation partition 121. Other surfaces opposite to the side surfaces may be in contact with the plurality of first nanosheets NS11 to NS13 or the first top nanosheet TNS1. FIG.2 illustrates that all side walls of the plurality of first nanosheets NS11 to NS13 facing the first insulation partition 121 may be covered with the first barriers 111. However, it is merely an example. In some example implementations, some of the side walls of the plurality of first nanosheet NS11 to NS13 facing the first insulation partition 121 may be in contact with the insulation liner HK.

According to an example implementation, a plurality of second barriers 112 may be interposed between the second insulation partition 122 and the second nanosheets NS21 to NS23 or between the second top nanosheet TNS2 and the second insulation partition 122. Side surfaces of the plurality of second barriers 112 may be in contact with the second insulation partition 122. Other surfaces opposite to the side surfaces may be in contact with the plurality of second nanosheets NS21 to NS23 or the second top nanosheet TNS2. FIG.2 illustrates that all side walls of the plurality of second nanosheets NS21 to NS23 facing the second insulation partition 122 may be covered with the second barriers 112. However, it is merely an example. In some example implementations, some of the side walls of the plurality of second nanosheet NS21 to NS23 facing the second insulation partition 122 may be in contact with the insulation liner HK.

According to an example implementation, a first barrier 111 and a second barrier 112 may include one of silicon nitride (SiN), silicon oxynitride (SiON), silicon oxide (SiO2), silicon oxycarbonitride (SiOCN), and a combination thereof.

According to an example implementation, with respect to a barrier, the first to sixth barriers 111 to 116 are not distinguished from each other. However, in order to assist in understanding the present disclosure, the barrier may be identified and described as one of the first to sixth barriers 111 to 116.

According to an example implementation, the first upper insulation partition 141 may be disposed above the first insulation partition 121 in the first direction D1. Together with the first insulation partition 121, the first upper insulation partition 141 may serve as a gate cut configured to separate the first gate line GL1 and the second gate line GL2. The first insulation partition 121 and the first upper insulation partition 141 may be formed of an insulation material and configured to prevent electrical interference between the first gate line GL1 and the second gate line GL2. The first upper insulation partition 141 may be extended along the third direction D3 and disposed to cross the first gate line GL1 and the second gate line GL2.

According to an example implementation, FIG. 2 illustrates that a width of the first upper insulation partition 141 along the second direction D2 is equal to a width of the first insulation partition 121 along the second direction D2. However, in some example implementations, the width of the first upper insulation partition 141 along the second direction D2 may be different from the width of the first insulation partition 121 along the second direction D2. Since the first upper insulation partition 141 is formed through a process other than that for the first insulation partition 121, the width of the first insulation partition 121 and the width of the first upper insulation partition 141 may be independent of each other.

According to an example implementation, the third gate line GL3 may be positioned above the second insulation partition 122. Unlike the first gate line GL1 and the second gate line GL2 which are spatially separated from each other by the first upper insulation partition 141, the third gate line GL3 may be disposed to surround the entire second nanosheet structure NS2. For example, the plurality of first nanosheets NS11 to NS13 and the first top nanosheet TNS1 which are disposed at a side of the first upper insulation partition 141 in the second direction D2 may be surrounded by the first gate line GL1 and configured to form a channel by a voltage applied to the first gate line GL1. The plurality of first nanosheets NS11 to NS13 and the first top nanosheet TNS1 which are disposed at another side of the first upper insulation partition 141 in a reverse direction -D2 of the second direction may be surrounded by the second gate line GL2 and configured to form a channel by a voltage applied to the second gate line GL2. In contrast, a plurality of second nanosheet structures NS2 all may be surrounded by the third gate line GL3 and configured to form a channel by a voltage applied to the third gate line GL3.

According to an example implementation, the field insulation partition 151 may be extended along the third direction D3 and disposed to cross the second gate line GL2 and the third gate line GL3. The field insulation partition 151 may be configured to serve as a gate cut that spatially and electrically separate the second gate line GL2 and the third gate line GL3. A lower surface of the field insulation partition 151 may be in contact with the device separator 105. A length of the field insulation partition 151 along the first direction D1 may be longer than a length of the first insulation partition 121 along the first direction D1 or a length of the second insulation partition 122 along the first direction D1.

According to an example implementation, the first to fifth gate lines GL1 to GL5 may include at least one of titanium nitride (TiN), a tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAlC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and a combination thereof. The first to fifth gate lines GL1 to GL5 may include a conductive metal oxide, a conductive metal oxynitride, or the like or may include an oxidized form of the above-described material.

According to an example implementation, a length of the field insulation partition 151 along the third direction D3 may be longer than or equal to a length of the first nanosheets NS11 to NS13 along the third direction D3 or a length of the second nanosheets NS21 to NS23 along the third direction D3.

According to an example implementation, FIGS. 2 and 4 illustrate that the first insulation partition 121, the second insulation partition 122, the first upper insulation partition 141, the second upper insulation partition 142, and the field insulation partition 151 have constant widths as being extended along the first direction D1. However, in some example implementations, the above-described insulation partitions may have a tapered shape of which a width is narrowed toward the substrate 100.

According to an example implementation, the first insulation partition 121, the second insulation partition 122, the first upper insulation partition 141, the second upper insulation partition 142, and the field insulation partition 151 may include one of silicon nitride (SiN), silicon oxynitride (SiON), silicon oxide (SiO2), silicon oxycarbonitride (SiOCN), a low-permittivity material, and a combination thereof.

According to an example implementation, a first interface layer IL1 may be formed along surfaces of the plurality of first nanosheets NS11 to NS13. The first interface layer IL1 may cover the surfaces of the first nanosheets NS11 to NS13. A first top interface layer TIL1 may include a material substantially identical to that of the first interface layer IL1 and may cover a surface of the first top nanosheet TNS1. Similarly, a second interface layer IL2 may cover surfaces of the second nanosheets NS21 to NS23, and a second top interface layer TIL2 may cover a surface of the second top nanosheet TNS2.

According to an example implementation, the insulation liner HK may cover the first interface layer IL1, the second interface layer IL2, the first top interface layer TIL1, and the second top interface layer TIL2. In some implementations, the insulation liner HK may cover the upper surface of the device separator 105, at least a portion of a side wall of the first insulation partition 121, a side wall of the first upper insulation partition 141, at least a portion of a side wall of the second insulation partition 122, an upper surface of the second insulation partition 122, and a side wall of the field insulation partition 151. The insulation liner HK may be interposed between a surface of the above-described elements and a surface of one of first to third gate lines GL1 to GL3.

According to an example implementation, the first interface layer IL1, the second interface layer IL2, the first top interface layer TIL1, and the second top interface layer TIL2 may include a dielectric material including silicon oxide, silicon oxynitride, silicon nitride, aluminum oxide, hafnium oxide, zirconium oxide, or a combination thereof. A third interface layer IL3, a fourth interface layer IL4, a third top interface layer TIL3, and a fourth top interface layer TIL4 to be described below may be similar thereto.

According to an example implementation, the insulation liner HK may include at least one of silicon oxide, silicon oxynitride, silicon nitride, and a high-permittivity material having a dielectric constant larger than that of silicon oxide.

According to an example implementation, the first insulation film 131 may be interposed between the first insulation partition 121 and the first upper insulation partition 141. A lower surface of the first insulation film 131 may be in contact with an uppermost surface 121_s of the first insulation partition 121. An upper surface of the first insulation film 131 may be in contact with a lower surface of the first upper insulation partition 141. At least a portion of a side wall of the first insulation film 131 may be in contact with the insulation liner HK.

According to an example implementation, the first insulation film 131 may include one of silicon nitride (SiN), silicon oxynitride (SiON), silicon oxide (SiO2), silicon oxycarbonitride (SiOCN), and a combination thereof. However, a material included in the first insulation film 131 is not limited to the above-described materials.

According to an example implementation, a thickness of the first insulation film 131 may range from 0.5 to 3 nanometers (nm).

According to an example implementation, a thickness of the insulation liner HK which is elongated along a length direction may be larger than those of the first interface layer IL1, the first top interface layer TIL1, the second interface layer IL2, and the second top interface layer TIL2.

According to an example implementation, the uppermost surface 121_s of the first insulation partition 121 may have a shape of which a center is concavely recessed in the reverse direction -D1 of the first direction. As described in detail below, an insulation material may be deposited in a space between the plurality of first nanosheets NS11 to NS13 spaced apart along the second direction, so that the first insulation partition 121 may be formed. After the insulation material is deposited, when an additional etching process such as an etch-back process is not performed, the uppermost surface 121_s of the first insulation partition 121 may have the shape of which the center is concave. In some example implementations, after the insulation material is deposited, when the additional etching process such as the etch-back process is performed, the uppermost surface 121_s of the first insulation partition 121 may have a planar shape.

According to an example implementation, the lower surface of the first insulation film 131 may have a shape that convexly protrudes in the reverse direction -D1 of the first direction. The lower surface of the first insulation film 131 may be in contact with the uppermost surface 121_s of the first insulation partition 121 and extended along an upper surface of the first upper insulation partition 121. The upper surface of the first insulation film 131 may have a shape of which a center is concavely recessed in the reverse direction -D1 of the first direction. The lower surface of the first upper insulation partition 141 disposed on the first insulation film 131 may have a shape that convexly protrudes in the reverse direction -D1 of the first direction. The lower surface of the first insulation film 141 may be in contact with the upper surface of the first insulation film 131 and extended along the upper surface of the first insulation film 131.

According to an example implementation, the first barrier 111 may be formed of a first insulation material, and the first insulation film 131 may be formed of a second insulation material. At this point, the first insulation material and the second insulation material may be different materials. Since being separately formed in different processes, the first barrier 111 and the first insulation film 131 may be elements formed of the different materials.

According to an example implementation, a level LV1 of an uppermost portion of the first insulation partition 121, which is along the first direction D1, may be positioned to be lower than a level LV2 of an uppermost portion of the first top nanosheet TNS1, which is along the first direction D1. The uppermost portion of the first insulation partition 121 may be a highest point of the uppermost surface 121_s of the first insulation partition 121. In some example implementations, the uppermost surface 121_s of the first insulation partition 121 may be curved, not evenly planar. The uppermost portion of the first insulation partition 121 may be defined as a highest point of the curved uppermost surface 121_s of the first insulation partition 121. In the present example implementation, since the uppermost surface 121_s of the first insulation partition 121 has the shape of which the center is concavely recessed, an outer portion thereof may be the uppermost portion of the first insulation partition 121. In some example implementations, when the uppermost surface 121_s of the first insulation partition 121 has a wavy pattern or a shape of which a center convexly protrudes, a crest of the wavy pattern or the center may be the uppermost portion of the first insulation partition 121.

Similarly, the uppermost portion of the first top nanosheet TNS1 may be a highest point of an uppermost surface TNS1_s of the first top nanosheet TNS1. In some example implementations, the uppermost surface TNS1_s of the first top nanosheet TNS1 may be curved, not evenly planar. The uppermost portion of the first top nanosheet TNS1 may be defined as the highest point of the curved uppermost surface TNS1_s of the first top nanosheet TNS1_s.

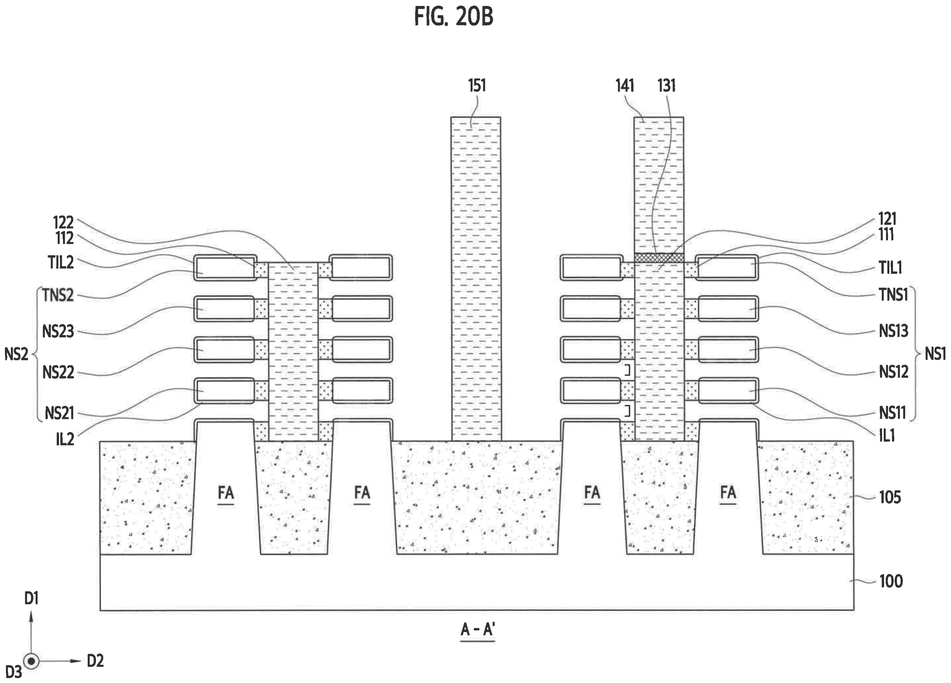

In another example implementation, when the first insulation material is deposited so that the first insulation partition 121 is formed, the uppermost portion of the first insulation partition 121 may be positioned at a level equal to that of the uppermost surface TNS1_s of the first top nanosheet TNS1 at an initial stage. Then, when a portion of an upper end portion of the first insulation partition 121 is etched in an etching process for forming the first barrier 111 or the like as illustrated in FIG. 20B, the level LV1 of the uppermost portion of the first insulation partition 121 may become lower than the level LV2 of the uppermost surface TNS1_s of the first top nanosheet TNS1.

According to an example implementation, a third nanosheet structure NS3 and a fourth nanosheet structure NS4 may be disposed above the active area FA. The third nanosheet structure NS3 may be a nanosheet structure spaced apart from the first nanosheet structure NS1 along the third direction D3. The fourth nanosheet structure NS4 may be a nanosheet structure spaced apart from the second nanosheet structure NS2 along the third direction D3. The third nanosheet structure NS3 may include a plurality of third nanosheets NS31 to NS33 and a third top nanosheet TNS3 which are arranged side by side along the first direction D1. Similarly to the first top nanosheet TNS1, the third top nanosheet TNS3 may be a nanosheet positioned at an uppermost end among nanosheets of the third nanosheet structure NS3 arranged along the first direction D1. The fourth nanosheet structure NS4 may include a plurality of fourth nanosheets NS41 to NS43 and a fourth top nanosheet TNS4 which are arranged side by side along the first direction D1. Similarly to the first top nanosheet TNS1, the fourth top nanosheet TNS4 may be a nanosheet positioned at an uppermost end among nanosheets of the fourth nanosheet structure NS4 arranged along the first direction D1. Since descriptions of the third nanosheet structure NS3 and the fourth nanosheet structure NS4 are similar to the above descriptions of the first nanosheet structure NS1 and the second nanosheet structure NS2 in substantial part, redundant descriptions will be omitted below.

According to an example implementation, a first source/drain area SD1 may be disposed between the first nanosheet structure NS1 and the third nanosheet structure NS3. According to an example implementation, a second source/drain area SD2 may be disposed between the second nanosheet structure NS2 and the fourth nanosheet structure NS4.

According to an example implementation, the first insulation partition 121 may also serve as a separator between the plurality of third nanosheets NS31 to NS33 spaced apart from each other along the second direction D2 and third top nanosheets TNS3 spaced apart from each other in the third nanosheet structure NS3. The first insulation partition 121 may be disposed between a fourth gate line GL4 and a fifth gate line GL5, between the plurality of third nanosheets NS31 to NS33 spaced apart from each other along the second direction D2, and between a pair of third top nanosheets TNS3 spaced apart from each other.

According to an example implementation, the second insulation partition 122 may serve as a separator between a plurality of fourth nanosheets NS41 to NS43 spaced apart from each other along the second direction D2 and fourth top nanosheets TNS4 spaced apart from each other in the fourth nanosheet structure NS4. The fifth gate line GL5 may be disposed to surround the second insulation partition 122. However, since not completely crossing the fifth gate line GL5 along the first direction D1, the second insulation partition 122 may not serve as a gate cut.

According to an example implementation, the fourth gate line GL4 may be disposed to be spaced apart from the first gate line GL1 along the third direction D3 with the inter-layer insulation film 160 and the first source/drain area SD1 in between. The fourth gate line GL5 may be disposed to be spaced apart from the second gate line GL2 and the third gate line GL3 along the third direction D3 with the inter-layer insulation film 160 and the second source/drain area SD2 in between.

According to an example implementation, the inter-layer insulation film 160 may surround the first source/drain area SD1 and the second source/drain area SD2 between gate lines spaced apart along the third direction D3 among the first to fifth gate lines GL1 to GL5. According to an example implementation, the inter-layer insulation film 160 may include one of silicon nitride (SiN), silicon oxynitride (SiON), silicon oxide (SiO2), silicon oxycarbonitride (SiOCN), and a combination thereof.

According to an example implementation, a plurality of third barriers 113 may be interposed between the first insulation partition 121 and the third nanosheets NS31 to NS33 or between the third top nanosheet TNS3 and the first insulation partition 121. Since a description of the plurality of third barriers 113 is similar to the above description of the plurality of first barriers 111 in substantial part, redundant descriptions will be omitted below.

According to an example implementation, a plurality of fourth barriers 114 may be interposed between the second insulation partition 122 and the fourth nanosheets NS41 to NS43 or between the fourth top nanosheet TNS4 and the second insulation partition 122. Since a description of the plurality of fourth barriers 114 is similar to the above description of the plurality of second barriers 112 in substantial part, redundant descriptions will be omitted below.

According to an example implementation, the second upper insulation partition 142 may be disposed above the first insulation partition 121 in the first direction D1. The second upper insulation partition 142 may be disposed to be spaced apart from the first upper insulation partition 141 along the third direction D3 above the first insulation partition 121. The second upper insulation partition 142 may serve as a gate cut configured to separate the fourth gate line GL4 and the fifth gate line GL5. The first insulation partition 121 and the second upper insulation partition 142 may be formed of an insulation material and configured to prevent electrical interference between the fourth gate line GL4 and the fifth gate line GL5. The second upper insulation partition 142 may be extended along the third direction D3 and disposed to cross the fourth gate line GL4 and the fifth gate line GL5.

According to an example implementation, similarly to the first upper insulation partition 141, FIG. 4 illustrates that a width of the second upper insulation partition 142 along the second direction D2 is equal to the width of the first insulation partition 121 along the second direction D2. However, in some example implementations, the width of the second upper insulation partition 142 along the second direction D2 may be different from the width of the first insulation partition 121 along the second direction D2.

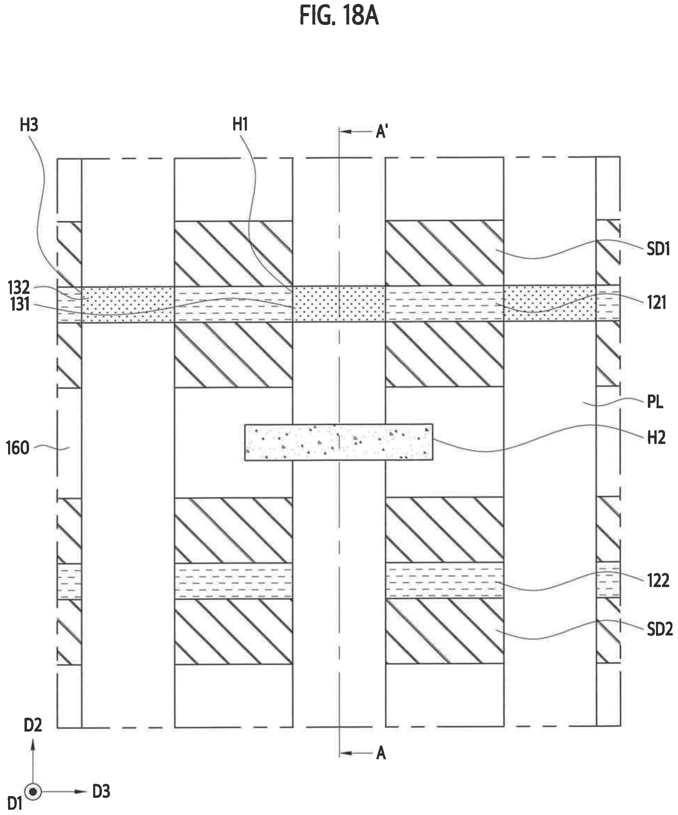

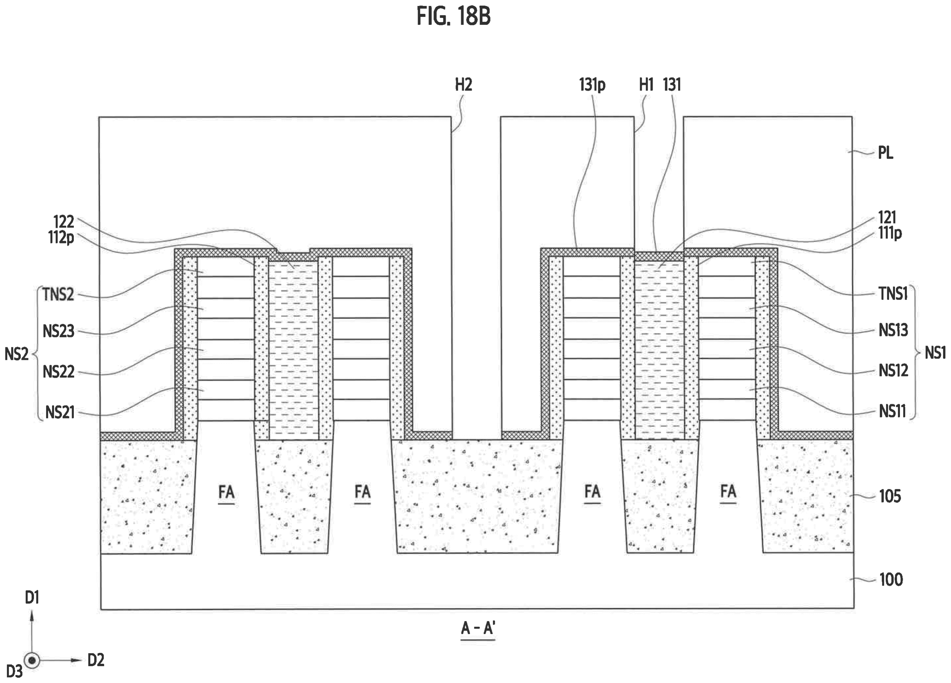

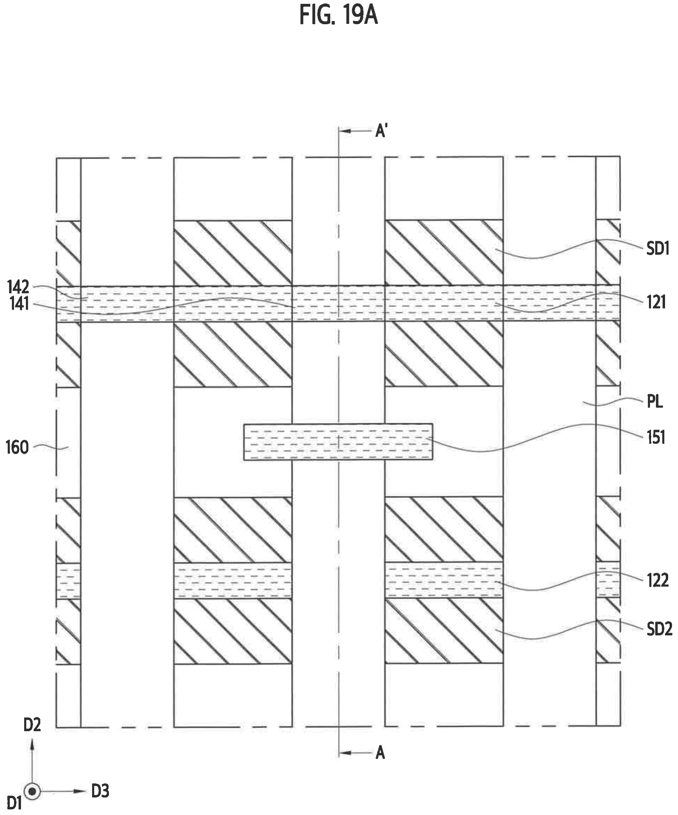

According to an example implementation, the width of the first upper insulation partition 141 along the second direction D2 and the width of the second upper insulation partition 142 along the second direction D2 may be equal to each other. However, as illustrated in FIGS. 19A and 19B, since the first upper insulation partition 141 and the second upper insulation partition 142 are formed by depositing an insulation material in different patterns (e.g., a first hole H1 (see FIGS. 18A and 18B) and a third hole H3 (see FIGS. 18A and 18B)) of a mask PL (see FIGS. 19A and 19B), widths of the first upper insulation partition 141 and the second upper insulation partition 142 may be different from each other depending on a pattern formed to the mask PL.

According to an example implementation, the fifth gate line GL5 may be positioned above the second insulation partition 122. As illustrated in FIG. 2, the field insulation partition 151 may be disposed between the first nanosheet structure NS1 and the second nanosheet structure NS2 to serve as the gate cut, but an insulation partition serving as a gate cut may not be disposed between the third nanosheet structure NS3 and the fourth nanosheet structure NS4.

According to an example implementation, the plurality of third nanosheets NS31 to NS33 which is disposed at a side of the second upper insulation partition 142 in the second direction D2 may be surrounded by the fourth gate line GL4 and configured to form a channel by a voltage applied to the fourth gate line GL4. The plurality of third nanosheets NS31 to NS33 and the entire fourth nanosheet NS4 which are disposed at another side of the second upper insulation partition 142 in the reverse direction -D2 of the second direction may be surrounded by the fifth gate line GL5 and configured to form a channel by a voltage applied to the fifth gate line GL5. Depending on logic design for the semiconductor device 10, a field insulation partition that separates the third nanosheet structure NS3 and the fourth nanosheet structure NS4 may be selectively formed.

According to an example implementation, the third interface layer IL3 may be formed along surfaces of the plurality of third nanosheets NS31 to NS33. The third interface layer IL3 may cover the surfaces of the third nanosheets NS31 to NS33. A third top interface layer TIL3 may include a material substantially identical to that of the third interface layer IL3 and may cover a surface of the third top nanosheet TNS3. Similarly, the fourth interface layer IL4 may cover surfaces of the fourth nanosheets NS41 to NS43, and the fourth top interface layer TIL4 may cover a surface of the fourth top nanosheet TNS4.

According to an example implementation, the insulation liner HK may cover the third interface layer IL3, the fourth interface layer IL4, the third top interface layer TIL3, and the fourth top interface layer TIL4. Also, the insulation liner HK may cover a side wall of the second upper insulation partition 142.

According to an example implementation, a thickness of the insulation liner HK which is elongated along a length direction may be larger than those of the third interface layer IL3, the third top interface layer TIL3, the fourth interface layer IL4, and the fourth top interface layer TIL4.

According to an example implementation, the second insulation film 132 may be interposed between the first insulation partition 121 and the second upper insulation partition 142. A lower surface of the second insulation film 132 may be in contact with an uppermost surface of the first insulation partition 121. An upper surface of the second insulation film 132 may be in contact with a lower surface of the second upper insulation partition 142. At least a portion of a side wall of the second insulation film 132 may be in contact with the insulation liner HK.

According to an example implementation, a material included the second insulation film 132 may be substantially identical to the material included in the first insulation film 131.

According to an example implementation, similarly to the first insulation film 131, a level of an uppermost surface portion of the second insulation partition 132, which is along the first direction D1, may be positioned to be lower than a level of an uppermost portion of the third top nanosheet TNS3, which is along the first direction D1. In some implementations, since being separately formed in different processes, the second insulation film 132 and a third barrier 113 may be elements formed of different materials. The second insulation film 132 may be substantially identical to the first insulation film 131, except that the second insulation film 132 is interposed between the first insulation partition 121 and the second upper insulation partition 142. Thus, since a description of the second insulation film 132 is similar to the above description of the first insulation film 131 in substantial part, redundant descriptions will be omitted below.

According to an example implementation, the first source/drain area SD1 may be disposed to be adjacent to the first nanosheet structure NS1 and the third nanosheet structure NS3 along the third direction D3 above the active area FA. For example, a plurality of pairs of first source/drain areas SD1, which is arranged to be spaced apart along the third direction D3, may be provided. A pair of first source/drain areas SD1 may be disposed to be spaced apart along the second direction D2 with a first insulation partition 121_a in between. The first source/drain area SD1 may be disposed between the first nanosheet structure NS1 and the third nanosheet structure NS3 which are spaced apart along the third direction D3.

According to an example implementation, the first source/drain area SD1 may be disposed to overlap the plurality of first nanosheets NS11 to NS13 and the first top nanosheet TNS1 along the third direction D3. FIG. 5 illustrates that the plurality of first nanosheets NS11 to NS13 and the first top nanosheet TNS1 exclusively overlap the first source/drain area SD1. However, the plurality of third nanosheets NS31 to NS33 and the third top nanosheet TNS3 also may overlap the first source/drain area SD1 along the third direction D3 at an opposite side.

According to an example implementation, the second source/drain area SD2 may be disposed to be adjacent to the second nanosheet structure NS2 and the fourth nanosheet structure NS4 along the third direction D3 above the active area FA. For example, a plurality of pairs of second source/drain areas SD2, which is arranged to be spaced apart along the third direction D3, may be provided. A pair of second source/drain areas SD2 may be disposed to be spaced apart along the second direction D2 with a second insulation partition 122_a in between. The second source/drain area SD2 may be disposed between the second nanosheet structure NS2 and the fourth nanosheet structure NS4 which are spaced apart along the third direction D3.

According to an example implementation, the second source/drain area SD2 may be disposed to overlap the plurality of second nanosheets NS21 to NS23 and the second top nanosheet TNS2 along the third direction D3. FIG. 5 illustrates that the plurality of second nanosheets NS21 to NS23 and the second top nanosheet TNS2 exclusively overlap the second source/drain area SD2. However, the plurality of fourth nanosheets NS41 to NS43 and the fourth top nanosheet TNS4 also may overlap the second source/drain area SD2 along the third direction D3 at an opposite side.

According to an example implementation, a fifth barrier 115 may be interposed between the first source/drain area SD1 and the device separator 105. A side wall of the fifth barrier 115 may be in contact with the insulation liner HK or the first insulation partition 121_a, and another side wall opposite to the side wall may be in contact with the active area FA. A sixth barrier 116 may be interposed between the second source/drain area SD2 and the device separator 105. A side wall of the sixth barrier 116 may be in contact with the insulation liner HK or the second insulation partition 122_a, and another side wall opposite to the side wall may be in contact with the active area FA. Since materials included in the fifth barrier 115 and the sixth barrier 116 are substantially identical to materials included in the first barrier 111 and the second barrier 112, redundant descriptions will be omitted.

According to an example implementation, the first insulation partition 121_a which is disposed between the pair of first source/drain areas SD1 may be a portion of the first insulation partition 121 which crosses the first nanosheet structure NS1 and the third nanosheet structure NS3 along the third direction D3. However, a level, along the first direction D1, of an uppermost surface 121_as of the first insulation partition 121_a disposed between the pair of first source/drain areas SD1 may be lower than a level, along the first direction D1, of the uppermost surface 121_s of the first insulation partition 121 which crosses the first nanosheet structure NS1 and the third nanosheet structure NS3 along the third direction D3.

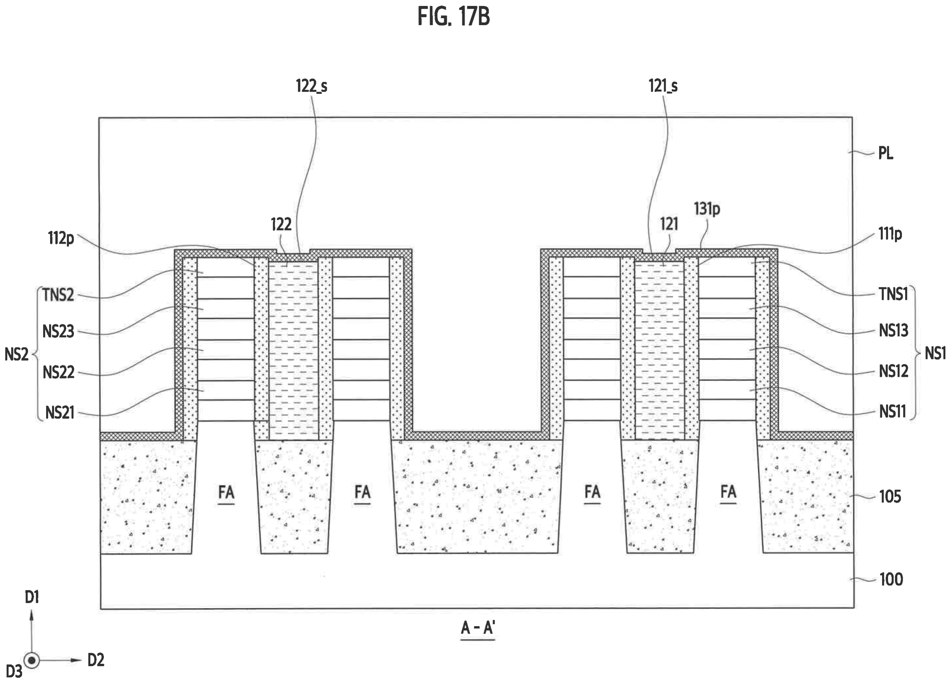

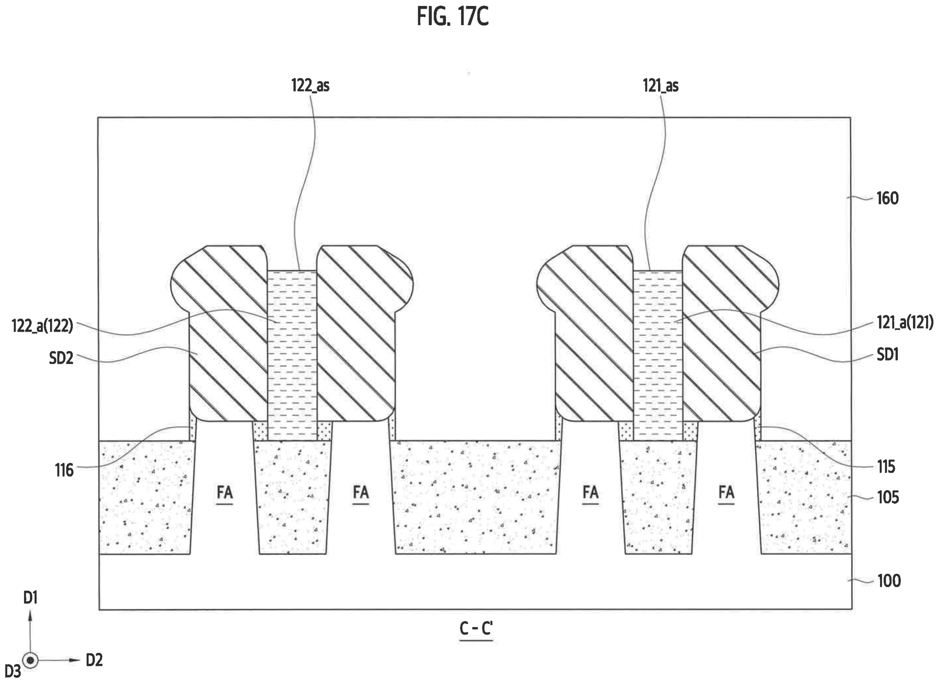

According to an example implementation, the second insulation partition 122_a which is disposed between the pair of second source/drain areas SD2 may be a portion of the first insulation partition 122 which crosses the second nanosheet structure NS2 and the fourth nanosheet structure NS4 along the third direction D3. Similarly, a level, along the first direction D1, of an uppermost surface 122_as of the second insulation partition 122_a disposed between the pair of second source/drain areas SD2 may be lower than a level, along the first direction D1, of an uppermost surface 122_s of the second insulation partition 122 which crosses the second nanosheet structure NS2 and the fourth nanosheet structure NS4 along the third direction D3. FIGS 17B and 17C will be referenced below for a detailed description thereof. A level of an uppermost surface described herein may refer to a level of an uppermost portion of a corresponding element.

The semiconductor device 10 according to an example implementation of the present disclosure may include the first insulation partition 121 which may serve to interrupt electrical interference between a pair of field-effect transistors (FETs). The first upper insulation partition 141 which may serve as the gate cut between the first gate line GL1 and the second gate line GL2 may be formed above the first insulation partition 121. The first insulation partition 121 and the first upper insulation partition 141 serving as the gate cut may not be formed together in one process. After the first insulation partition 121 is formed earlier, the first upper insulation partition 141 may be formed in a different subsequent process. Accordingly, a gate cut that is structurally more stable may be implemented.

Also, since the first insulation partition 121 which is formed at an initial stage does not serve as a gate cut, the uppermost portion of the first insulation partition 121 may be formed at a level lower than that of the uppermost portion of the first top nanosheet TNS1.

When an insulation partition is formed higher than a top nanosheet in a single process, an upper end portion of the insulation partition, which may serve as a gate cut, may not be required depending on a logic design. In this case, an additional process for removing an upper end of the insulation partition may be required.

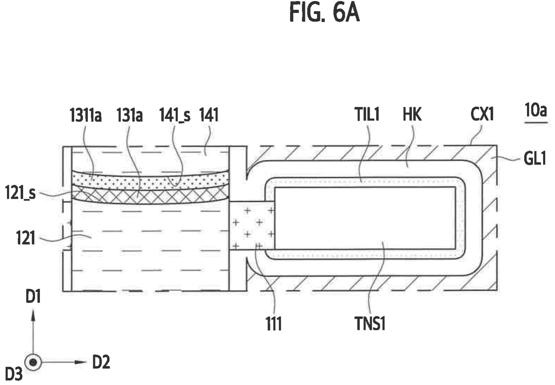

FIG. 6A is a diagram for describing a semiconductor device according to another example implementation of the present disclosure and an example diagram corresponding to a section marked "CX1" of FIG. 2.

A semiconductor device 10a illustrated in FIG. 6A is approximately identical or similar to the semiconductor device 10 illustrated in FIG. 3, except that elements and structures of insulation films interposed between the first insulation partition 121 and the first upper insulation partition 141 are different. Thus, redundant descriptions similar to those of the semiconductor device 10 illustrated in FIG. 3 will be omitted or simplified.

Referring to FIG. 6A, the semiconductor device 10a according to an example implementation may include a first insulation film 131a and a material layer 1311a that are interposed between the first insulation partition 121 and the first upper insulation partition 141. A double layer formed with the first insulation film 131a and the material layer 1311a may be interposed between the first insulation partition 121 and the first upper insulation partition 141. A material forming the first insulation film 131a may be substantially identical to a material forming the first insulation film 131 (see FIG. 3).

According to an example implementation, the material layer 1311a may include all materials other than a metal exclusively formed of a metallic element. For example, the material layer 1311a may include hafnium oxide (HfOx), a metal oxide, a low-permittivity material, silicon oxide, and other dielectric materials. A material included in the material layer 1311a is not limited to the above-describe materials. The material included in the material layer 1311a may be a material different from a first insulation material included in the first barrier 111 and a second insulation material included in the first insulation film 131a.

According to an example implementation, a sum of thicknesses of the first insulation film 131a and the material layer 1311a may range from 0.5 to 3 nanometers (nm).

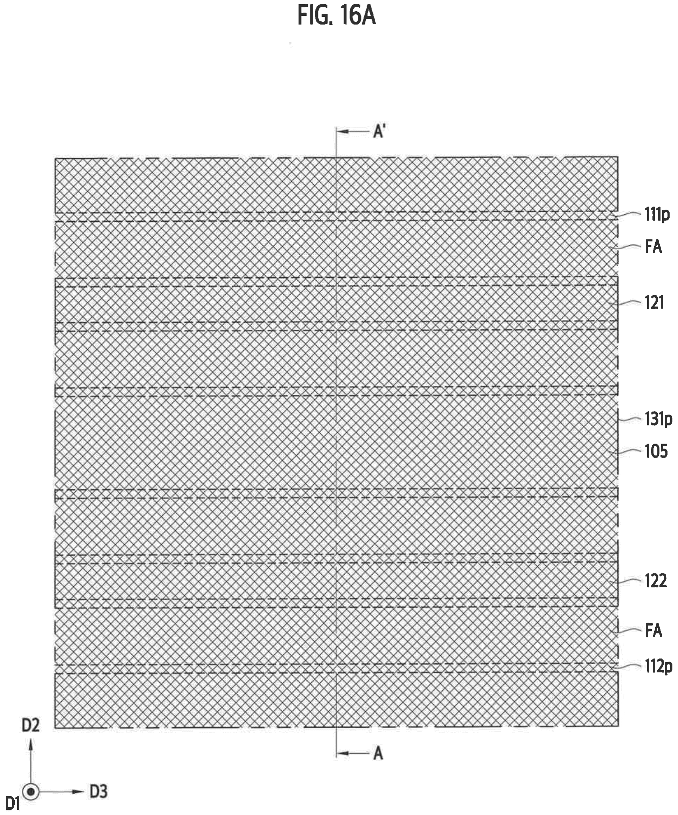

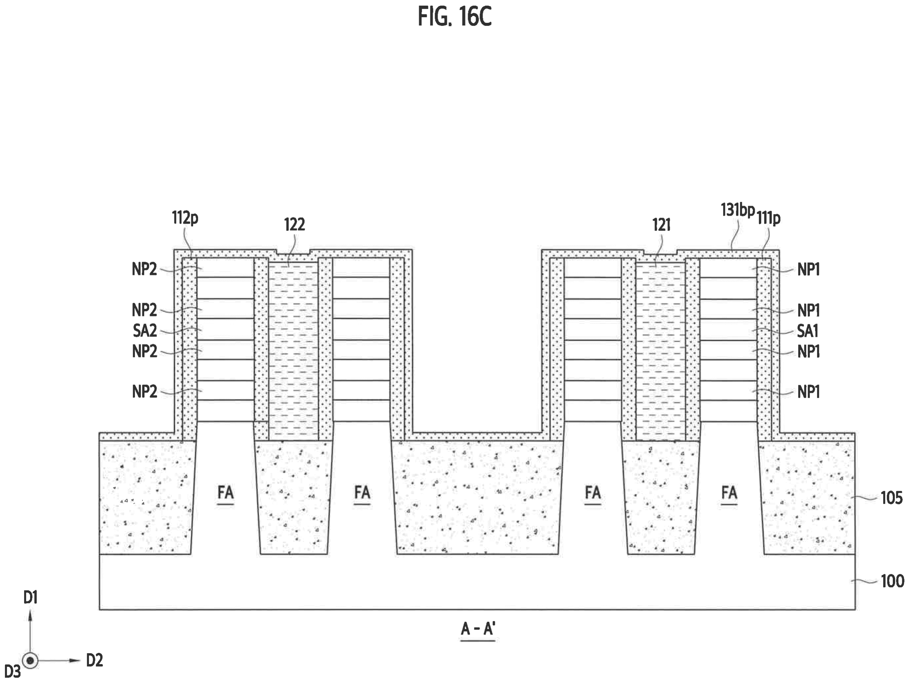

According to an example implementation, an insulation material layer 131p (see FIG. 16) may be deposited on the first insulation partition 121 as illustrated in FIGS. 16A and 16B below in order to form the first insulation film 131. When the insulation material layer 131p is a double-layered structure formed of different materials, the first insulation film 131a and the material layer 1311a may be interposed between the first insulation partition 121 and the first upper insulation partition 141 as illustrated in FIG. 6A.

According to an example implementation, the first insulation film 131a may be extended and in contact with along the uppermost surface 121_s of the first insulation partition 121. The material layer 1311a may be extended along and in contact with a lower surface 141_s of the first upper insulation partition 141.

In the present disclosure, a lower surface of the material layer 1311a may have a shape of which a center convexly protrudes in the reverse direction -D1 of the first direction. An upper surface of the material layer 1311a may have a shape of which a center is concavely recessed in the reverse direction -D1 of the first direction. However, profiles of the lower surface and the upper surface of the material layer 1311a are not limited to the above description.

FIG. 6A illustrates the material layer 1311a interposed between the first insulation film 131a and the first upper insulation partition 141, but another material layer may be interposed also between the second insulation film 132 and the second upper insulation partition 142 illustrated in FIG. 4.

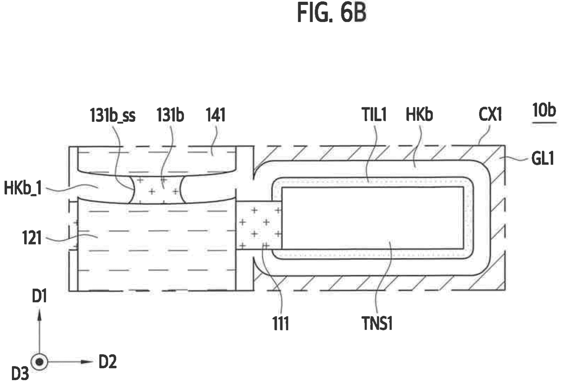

FIG. 6B is a diagram for describing a semiconductor device according to another example implementation of the present disclosure and an example diagram corresponding to a section marked "CX1" of FIG. 2.

A semiconductor device 10b illustrated in FIG. 6B is approximately identical or similar to the semiconductor device 10 illustrated in FIG. 3, except that an element and a structure of a first insulation film 131b interposed between the first insulation partition 121 and the first upper insulation partition 141 are different. Thus, redundant descriptions similar to those of the semiconductor device 10 illustrated in FIG. 3 will be omitted or simplified.

Referring to FIG. 6B, the semiconductor device 10b according to an example implementation may include the first insulation film 131b which is interposed between the first insulation partition 121 and the first upper insulation partition 141. A material forming the first insulation film 131b may be substantially identical to a material forming the first barrier 111. For example, a first insulation material included in the first barrier 111 and a second insulation material included in the first insulation film 131b may be an identical material.

According to an example implementation, a side wall 131b_ss of the first insulation film 131b may have a profile concavely recessed toward a center. A protrusion portion HKb_1 of the insulation liner HK may be interposed between the first insulation partition 121 and the first upper insulation partition 141. The protrusion portion HKb_1 may be in contact with the concave side wall 131b_ss of the first insulation film 131b. An upper surface of the protrusion portion HKb_1 of the insulation liner HK may be in contact with the first upper insulation partition 141, a lower surface thereof may be in contact with the first insulation partition 121, and a side wall thereof may be in contact with the first insulation film 131b.

According to an example implementation, a width of the first insulation film 131b along the second direction D2 may be smaller than a width of the first insulation partition 121 along the second direction D2 and a width of the first upper insulation partition 141 along the second direction D2.

According to an example implementation, then, an insulation material layer 131bp (see FIG. 16C) may be deposited on the first insulation partition 121 as illustrated in FIG. 16C in order to form the first insulation film 131b. When the insulation material layer 131bp is formed of a material identical to that of a first barrier film 111p (see FIG. 16C), the first insulation film 131b illustrated in FIB. 6B may be formed between the first insulation partition 121 and the first upper insulation partition 141.

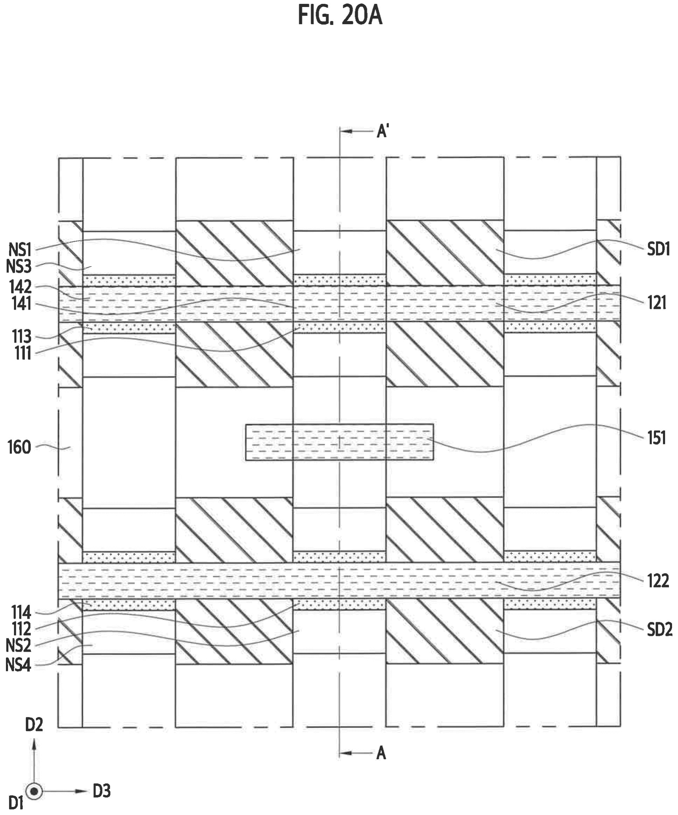

According to an example implementation, as illustrated in a process of progressing to FIGS. 20A and 20B from a process of FIGS. 19A and 19B, an etching process on a portion of the first barrier film 111p (see FIG. 19B) may be performed in order to form the first barrier 111. At this point, when the insulation material layer 131bp and the first barrier film 111p are formed of an identical material, etching may be also performed from an outer portion of the insulation material layer 131bp together with the first barrier film 111p. In this process, the insulation material layer 131bp may be gradually removed from the outer portion, and the first insulation film 131b of which the width is smaller than those of the first insulation partition 121 and the first upper insulation partition 141 and of which the side wall 131b_ss is concavely recessed as illustrated in FIG. 6B.

FIG. 6B illustrates the first insulation film 131b interposed between the first insulation partition 121 and the first upper insulation partition 141, but an insulation film having a structure similar to that of the first insulation film 131b may be interposed also between the second insulation film 132 and the second upper insulation partition 142 illustrated in FIG. 4.

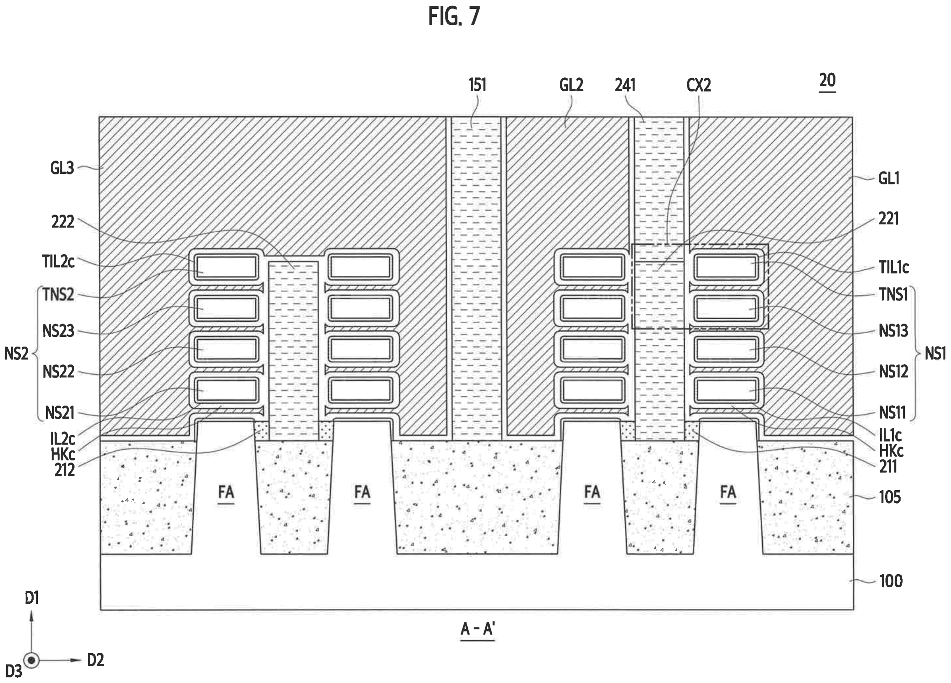

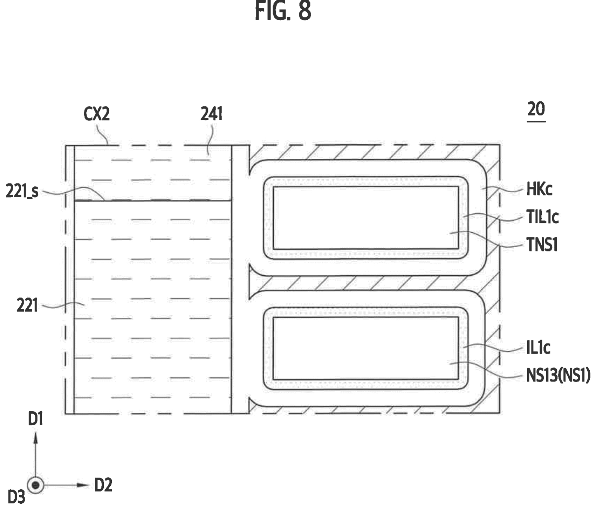

FIG. 7 is a diagram for describing a semiconductor device according to another example implementation of the present disclosure and an example diagram corresponding to a cross section taken long line A-A' of FIG. 1. FIG. 8 is an example diagram illustrating an enlargement of a section marked "CX2" of FIG. 7.

A semiconductor device 20 illustrated in FIGS. 7 and 8 is approximately identical or similar to the semiconductor device 10 illustrated in FIGS. 2 and 3, except that an insulation film is not interposed between a first insulation partition 221 and a first upper insulation partition 241 and that a barrier is not interposed between the first nanosheet structure NS1 and the first insulation partition 221 and between the second nanosheet structure NS2 and a second insulation partition 222. Thus, redundant descriptions similar to those of the semiconductor device 10 illustrated in FIGS. 2 and 3 will be omitted or simplified.

According to an example implementation, in a cross section crossing the third direction D3, four surfaces of each of the plurality of first nanosheets NS11 to NS13 may be in contact with a first interface layer IL1c. An element corresponding to the first barrier 111 (see FIG. 2) may not be interposed between the first insulation partition 221 and the plurality of nanosheets NS11 to NS13. The first interface layer IL1c and an insulation liner HKc may be interposed between the first insulation partition 221 and the plurality of nanosheets NS11 to NS13. Similarly, four surfaces of the first top nanosheet TNS1 may be in contact with a first top interface layer TIL1c, and the first top interface layer TIL1c and the insulation liner HKc may be interposed between the first top nanosheet TNS1 and the first insulation partition 221 or the first upper insulation partition 241. Exemplarily, each of the plurality of first nanosheets NS11 to NS13 and the first top nanosheets TSN1 has a quadrangular shape in a cross-section taken along a plane defined by the first direction D1 and second directionD2.

According to an example implementation, a first barrier 211 may be disposed between the first insulation partition 221 and a portion of the active area FA which protrudes from the device separator 105 in the first direction D1. A side wall of the first barrier 211 may be in contact with the active area FA, and another side wall opposite to the side wall may be in contact with the first insulation partition 221.

According to an example implementation, similarly to the first nanosheets NS11 to NS13, in a cross section crossing the third direction D3, four surfaces of each of the plurality of second nanosheets NS21 to NS23 may be in contact with a second interface layer IL2c. Similarly, four surfaces of the second top nanosheet TNS2 may be in contact with a second top interface layer TIL2c, and the second top interface layer TIL2c and the insulation liner HKc may be interposed between the second top nanosheet TNS2 and the second insulation partition 222. Exemplarily, each of the plurality of second nanosheets NS21 to NS23 and the second top nanosheets TSN2 has a quadrangular shape in a cross-section taken along a plane defined by the first direction D1 and second directionD2.

According to an example implementation, a second barrier 212 may be disposed between the second insulation partition 222 and a portion of the active area FA which protrudes from the device separator 105 in the first direction D1. A side wall of the second barrier 212 may be in contact with the active area FA, and another side wall opposite to the side wall may be in contact with the second insulation partition 222.

According to an example implementation, an uppermost surface 221_s of the first insulation partition 221 may be in contact with a lower surface of the first upper insulation partition 241. Another material may not be interposed between the first insulation partition 221 and the first upper insulation partition 241, and the first insulation partition 221 and the first upper insulation partition 241 may be in contact with each other.

According to an example implementation, as illustrated in FIGS. 18A and 18B, an etching process may be performed in order to form, to the mask PL (see FIG. 18B), the first hole H1 (see FIG. 18B) which overlaps the first insulation partition 221. After the first hole H1 is formed, a portion of the insulation material layer 131p (see FIG. 18B) which is deposited on the first insulation partition 221 may be etched, so that the first insulation film 131 (see FIG. 18B) may be formed. However, when the etching process on the insulation material layer 131p is excessively performed, the insulation material layer 131p which is disposed on the first insulation partition 221 may be completely removed. When a process of forming the first upper insulation partition 241 in FIGS. 19A and 19B is performed in a state in which the insulation material layer 131p is completely removed, a structure in which the first insulation partition 221 and the first upper insulation partition 241 are in contact with each other as illustrated in FIGS. 7 and 8 may be formed.

Also, as illustrated in FIGS. 20A and 20B, an etching process on a portion of the first barrier film 111p (see FIG. 19B) may be performed in order to form the first barrier 111 (see FIG. 20B). At this point, when the etching process on the first barrier film 111p is excessively performed, the first barrier film 111p between the first nanosheet structure NS1 and the first insulation partition 221 may be completely removed. When the first interface layer IL1c and the first top interface layer TIL1c are formed on the first nanosheet structure NS1 in a state in which the first barrier film 111p is completely removed, a structure in which the first interface layer IL1c and the insulation liner HKc or the first top interface layer TIL1c and the insulation liner HKc are interposed between the first nanosheet structure NS1 and the first insulation partition 221 as illustrated in FIGS. 7 and 8 may be formed.

Similarly, when an etching process on a second barrier film 112p (see FIG. 19B) is excessively performed, the second barrier film 112p which is between the second nanosheet structure NS2 and the second insulation partition 222 may be completely removed, and a structure in which the second interface layer IL2c and the insulation liner HKc or the second top interface layer TIL2c and the insulation liner HKc are interposed between the second nanosheet structure NS2 and the second insulation partition 222 may be formed.

Descriptions for FIGS. 7 and 8 focus on a cross section taken along line A-A' of FIG. 1. However, an element corresponding to the third barrier 113 (see FIG. 4) also may not be interposed between the third nanosheet structure NS3 (see FIG. 4) and the first insulation partition 221, and a structure in which the third interface layer IL3 (see FIG. 4) and the insulation liner HKc or the third top interface layer TIL3 (see FIG. 4) and the insulation liner HKc are interposed between the third nanosheet structure NS3 and the first insulation partition 221 may be formed. Also, an element corresponding to a fourth barrier 114 (see FIG. 4) may not be interposed between the fourth nanosheet structure NS4 (see FIG. 4) and the second insulation partition 222, and a structure in which the fourth interface layer IL4 (see FIG. 4) and the insulation liner HKc or the fourth top interface layer TIL4 (see FIG. 4) and the insulation liner HKc are interposed between the fourth nanosheet structure NS4 and the second insulation partition 222 may be formed.

In some implementations, an element corresponding to the second insulation film 132 (see FIG. 4) may not be interposed between the first insulation partition 221 and the second upper insulation partition 142 (see FIG. 4), and the first insulation partition 221 and the second upper insulation partition 142 may be in contact with each other. An element corresponding to the third barrier 113 (see FIG. 4) may be disposed between the first insulation partition 221 and a portion of the active area FA protruding from the device separator 105 in the first direction D1, and an element corresponding to the fourth barrier 114 (see FIG. 4) may be disposed between the second insulation partition 222 and a portion of the active area FA.

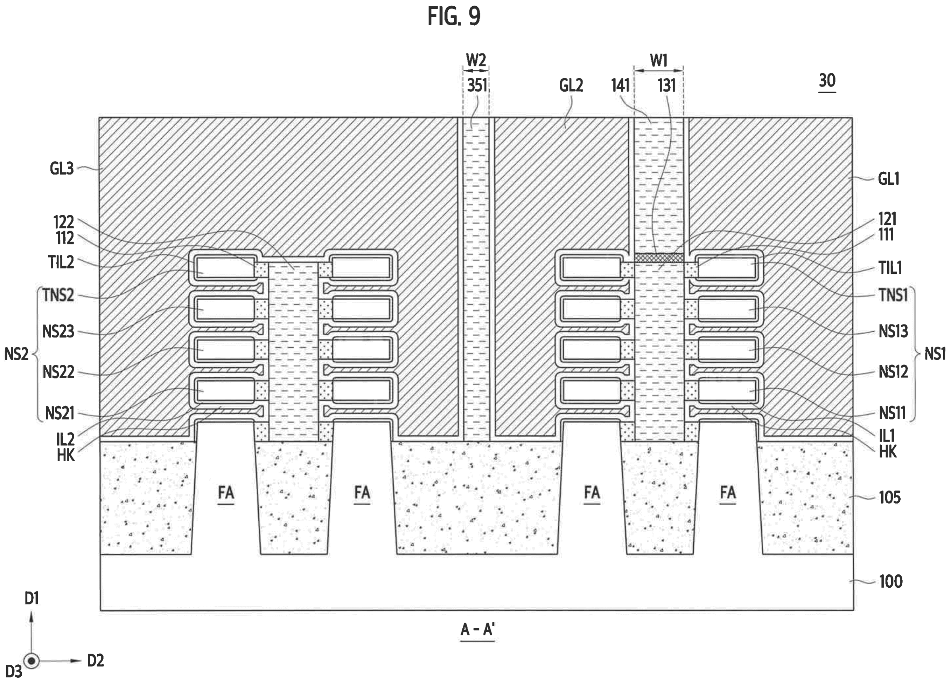

FIG. 9 is a diagram for describing a semiconductor device according to another example implementation of the present disclosure and an example diagram corresponding to a cross section taken along line A-A' of FIG. 1.

A semiconductor device 30 illustrated in FIG. 9 may be approximately identical or similar to the semiconductor device 10 illustrated in FIGS. 2 and 3, except that a width of a field insulation partition 351 along the second direction D2 is different from a width of the first upper insulation partition 141 along the second direction D2. Thus, redundant descriptions similar to those of the semiconductor device 10 illustrated in FIGS. 2 and 3 will be omitted or simplified.

According to an example implementation, the first hole H1 (see FIG. 18B) and a second hole H2 (see FIG. 18B) for forming the field insulation partition 351 and the first upper insulation partition 141 to the mask PL (see FIG. 18B) may be formed as illustrated in FIGS. 18A and 18B. Due to the first insulation partition 121, a length of the field insulation partition 351 along the first direction D1 may be longer than a length of the first upper insulation partition 141 along the first direction D1. As observed in reactive ion etching (RIE) lag or inverse reactive ion etching (inverse RIE) lag, a width of a hole or a trench formed in an etching process may be a factor that affects a depth. Alternatively, as observed in loading effect, closeness of the first hole H1 or the second hole H2 to another hole also may be a factor that affects the depth.

According to an example implementation, since the first hole H1 and the second hole H2 may be formed simultaneously in an identical etching process, in some example implementations, widths of the first hole H1 and the second hole H2 may be formed to be different in order to form the first hole H1 and the second hole H2 which have different depths. Widths of the first upper insulation partition 141 and the field insulation partition 351 which are formed as an insulation material fills the first hole H1 and the second hole H2 having the different widths may be different.

According to an example implementation, that widths of elements are different may include that widths of the elements at an identical level along the first direction D1, which are along the second direction D2 and/or the third direction D3, are different.

In another example implementation, when the first hole H1 and the second hole H2 are formed in sequential order through different etching processes, not at once, the widths of the first hole H1 and the second hole H2 may be formed to be equal to each other.

A width W2 of the field insulation partition 351 along the second direction D2 illustrated in FIG. 9 may be smaller than a width W1 of the first upper insulation partition 141 along the second direction D2. In some example implementations, the width W2 of the field insulation partition 351 along the second direction D2 may be larger than the width W1 of the first upper insulation partition 141 along the second direction D2.

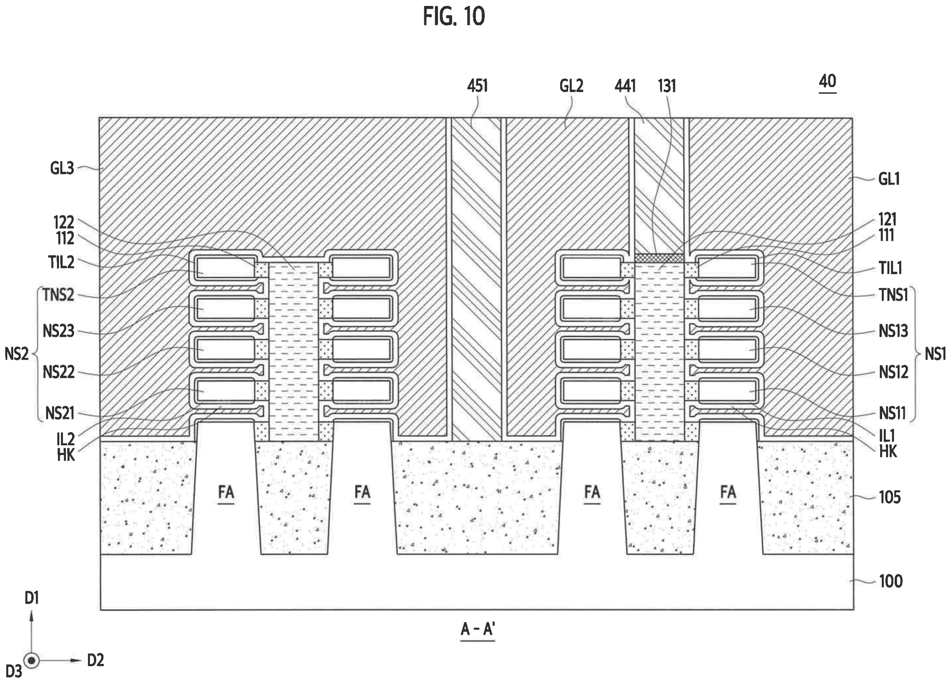

FIG. 10 is a diagram for describing a semiconductor device according to another example implementation of the present disclosure and an example diagram corresponding to a cross section taken long line A-A' of FIG. 1.

A semiconductor device 40 illustrated in FIG. 10 may be approximately identical or similar to the semiconductor device 10 illustrated in FIGS. 2 and 3, except that a material forming a first upper insulation partition 441 and a field insulation partition 451 is different from a material forming the first insulation partition 121 and the second insulation partition 122. Thus, redundant descriptions similar to those of the semiconductor device 10 illustrated in FIGS. 2 and 3 will be omitted or simplified.

According to an example implementation, insulation materials forming the first upper insulation partition 441 and the field insulation partition 451 may be identical. However, a material forming the first upper insulation partition 441 and a material forming the first insulation partition 121 and the second insulation partition 122 may be different.

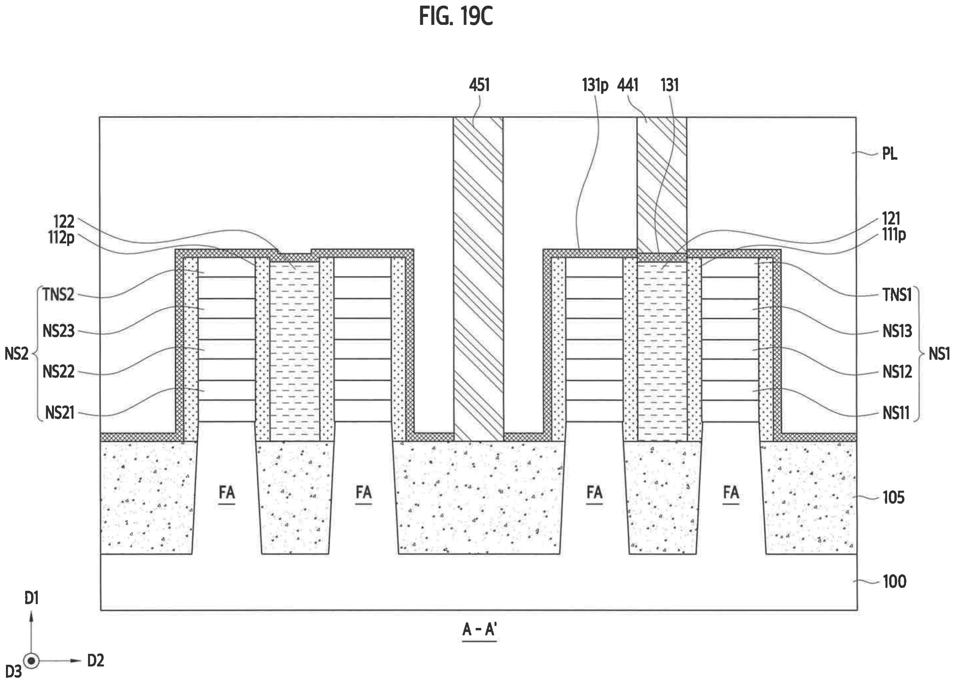

According to an example implementation, as illustrated in FIG. 19C, the first upper insulation partition 441 and the field insulation partition 451 may be formed by using patterning through an etching process and a deposition process after the first insulation partition 121 and the second insulation partition 122 are formed earlier. Thus, a process of forming the first insulation partition 121 and the second insulation partition 122 and a process of forming the first upper insulation partition 441 and the field insulation partition 451 may be different processes having different places in an order.

According to an example implementation, at a time of forming the first upper insulation partition 441 and the field insulation partition 451, when an insulation material different from an insulation material forming the first insulation partition 121 is deposited in the first hole H1 and the second hole H2, the first upper insulation partition 441 and the field insulation partition 451 which are illustrated in FIG. 10 may be formed.

A description for FIG. 10 focuses on the cross section taken along the line A-A' of FIG. 1. However, an insulation material forming an element corresponding to the second upper insulation partition 142 illustrated in FIG. 4 may be also different from an insulation material forming the first insulation partition 121 and the second insulation partition 122.

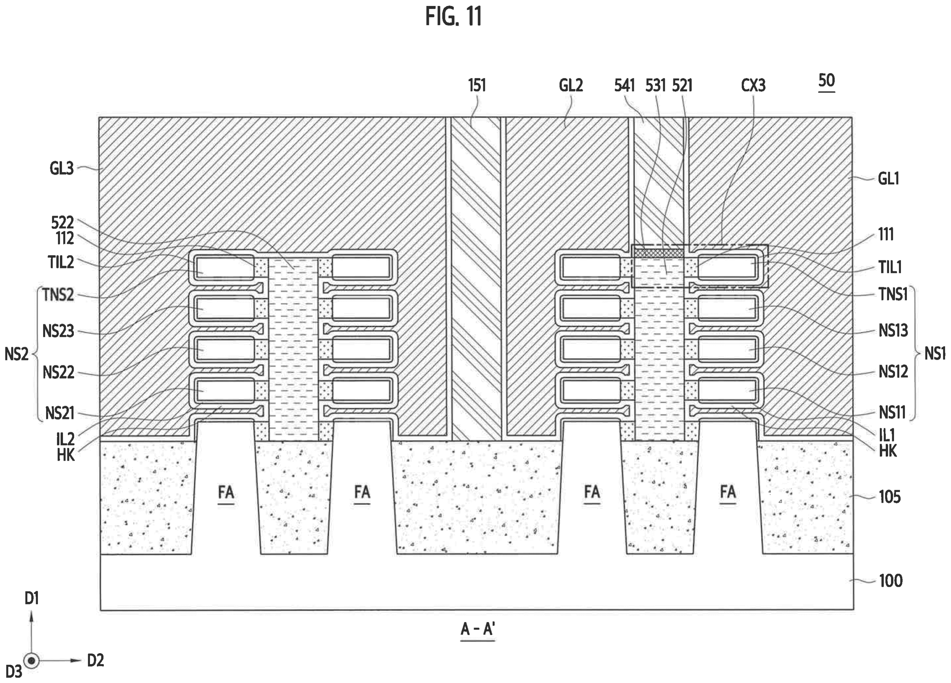

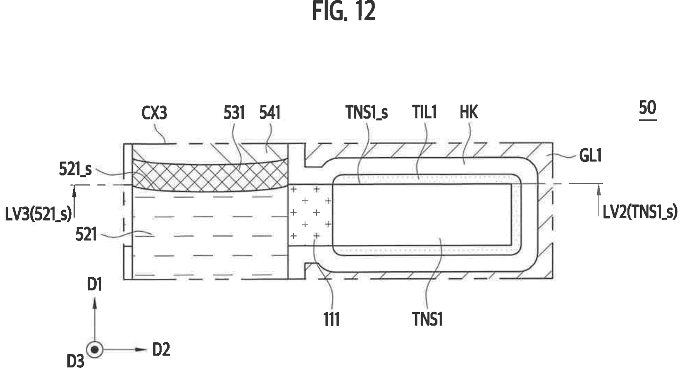

FIG. 11 is a diagram for describing a semiconductor device according to another example implementation of the present disclosure and an example diagram corresponding to a cross section taken long line A-A' of FIG. 1. FIG. 12 is an example diagram illustrating an enlargement of a section marked "CX3" of FIG. 11.

A semiconductor device 50 illustrated in FIG. 11 may be approximately identical or similar to the semiconductor device 10 illustrated in FIGS. 2 and 3, except that a level LV3 of an uppermost portion of an uppermost surface 521_s of a first insulation partition 521 is equal to the level LV2 of the uppermost surface TNS1_s of the first top nanosheet TNS1. Thus, redundant descriptions similar to those of the semiconductor device 10 illustrated in FIGS. 2 and 3 will be omitted or simplified.

According to an example implementation, the level LV3 of the uppermost portion of the uppermost surface 521_s of the first insulation partition 521, which is along the first direction D1, may be equal to the level LV2 of the uppermost surface TNS1_s of the first top nanosheet TNS1, which is along the first direction D1. In some example implementations, the uppermost surface 521_s of the first insulation partition 521 may be curved, not evenly planar. The uppermost portion of the first insulation partition 521 may be defined as a highest point of the curved uppermost surface 521_s of the first insulation partition 521.

Descriptions for FIGS. 11 and 12 focus on the cross section taken along the line A-A' of FIG. 1. However, the uppermost portion of the first insulation partition 521 may be positioned at a level equal to that of an uppermost portion of an element corresponding to the third top nanosheet TNS3 (see FIG. 4).

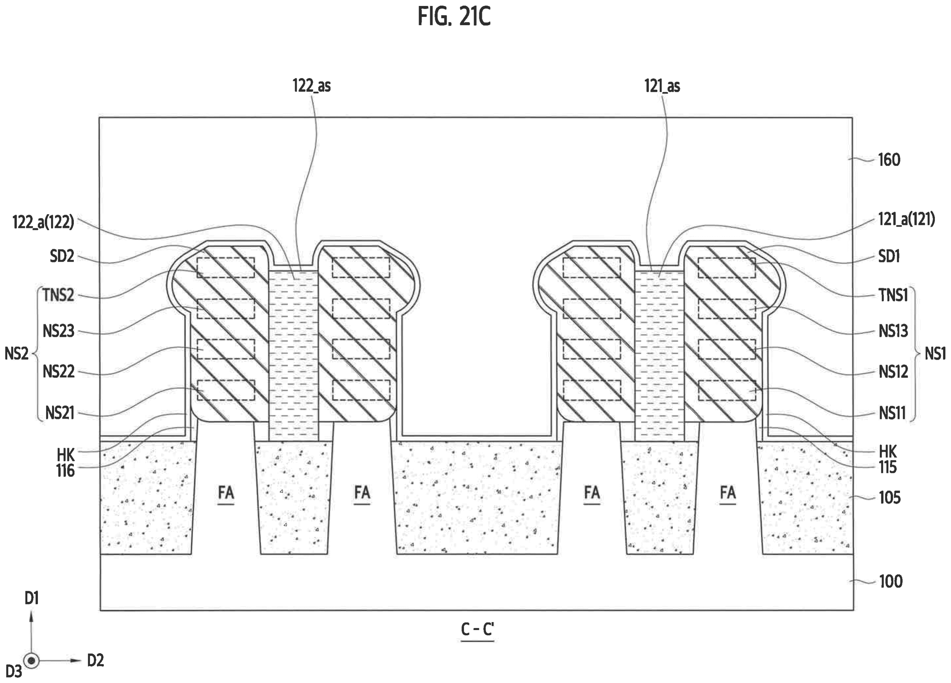

FIGS. 13A, 13B, 14A, 14B, 15A, 15B, 16A through 16C, 17A through 17C, 18A, 18B, 19A through 19C, 20A, 20B, and 21A through 21Care diagrams illustrated in process order for describing a method of manufacturing a semiconductor device according to an example implementation of the present disclosure. FIGS. 13A, 14A, 15B, 16A, 17A, 18A, 19A, 20A, and 21A are layout diagrams. FIGS. 13B, 14B, 15B, 16B, 17B, 18B, 19B, 20B, and 21B are diagrams corresponding to a cross section taken along line A-A' of FIG. 1. FIGS. 17C and 21C are diagrams corresponding to a cross section taken along line C-C' of FIG. 1. FIGS. 16C and 19C are cross-sectional diagrams for describing the method of manufacturing the semiconductor device according to another example implementation and example diagrams corresponding to FIGS. 16B and 19B.

Hereinafter, methods of manufacturing the semiconductor device according to an example implementation will be described in the process order.

Referring to FIGS. 13A and 13B, a stack structure in which a plurality of sacrificial films SA1 and SA2 and a plurality of nano-patterns NP1 and NP2 are alternately stacked above the active area FA on the substrate 100 may be formed. For example, the nano-patterns NP1 and NP2 may be formed at an uppermost portion of the stack structure, and the plurality of nano-patterns NP1 and NP2 and the plurality of sacrificial films SA1 and SA2 may be alternately arranged toward the substrate 100. However, it is merely an example. In another example implementation, the sacrificial films SA1 and SA2 may be formed at the uppermost portion of the stack structure.

According to an example implementation, when a plurality of trenches extended along the third direction D3 and spaced apart along the second direction D2 are formed after a sacrificial material and a semiconductor layer are alternately stacked above the substrate 100, the plurality of active areas FA, the plurality of sacrificial films SA1 and SA2, and the plurality of nano-patterns NP1 and NP2 may be formed. Then, through a deposition process, the device separator 105 may be formed in a space between the plurality of active areas FA which is spaced apart along the second direction D2.

According to an example implementation, the plurality of sacrificial films SA1 and SA2 and the plurality of nano-patterns NP1 and NP2 may be formed of different semiconductor materials. The plurality of nano-patterns NP1 and NP2 may be formed of a single material. In some example implementations, the plurality of nano-patterns NP1 and NP2 may be formed of a material identical to a material forming the substrate 100 and the active area FA. The plurality of sacrificial films SA1 and SA2 may include, for example, silicon germanium (SiGe), but it is merely an example. The plurality of nano-patterns NP1 and NP2 may include a material identical to those of the first to fourth nanosheet structures NS1 to NS4 illustrated in FIG. 2 and 4.

According to an example implementation, all the plurality of sacrificial films SA1 and SA2 may be formed to have an equal thickness, but it is merely an example. In some example implementations, a thickness of a first sacrificial film SA1 or a second sacrificial film SA2 closest to the substrate 100 among the plurality of sacrificial films SA1 and SA2 may be larger than a thickness of another first sacrificial film SA1 or second sacrificial film SA2.

According to an example implementation, a plurality of first nano-patterns NP1 and a plurality of first sacrificial films SA1 may be alternately arranged along the first direction D1, and a plurality of second nano-patterns NP2 and a plurality of second sacrificial films SA2 may be alternately arranged along the first direction D1.

According to an example implementation, the plurality of nano-patterns NP1 and NP2 and the plurality of sacrificial films SA1 and SA2 may be elongated along the third direction D3.

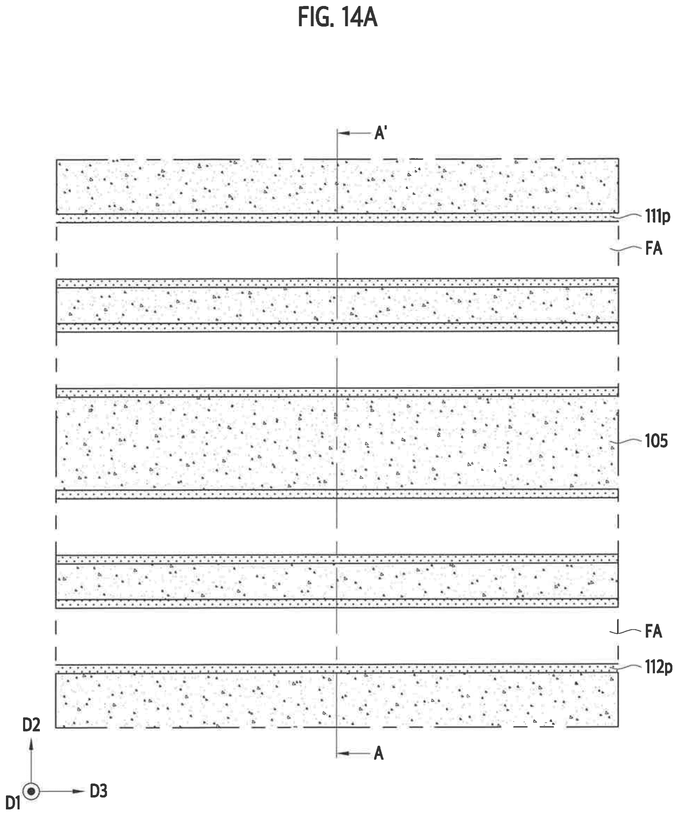

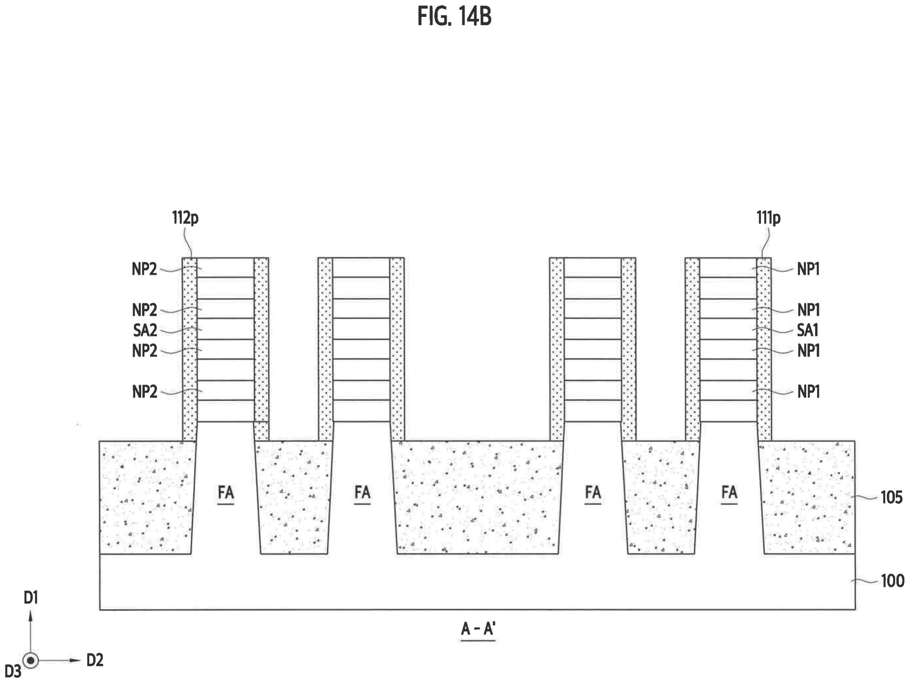

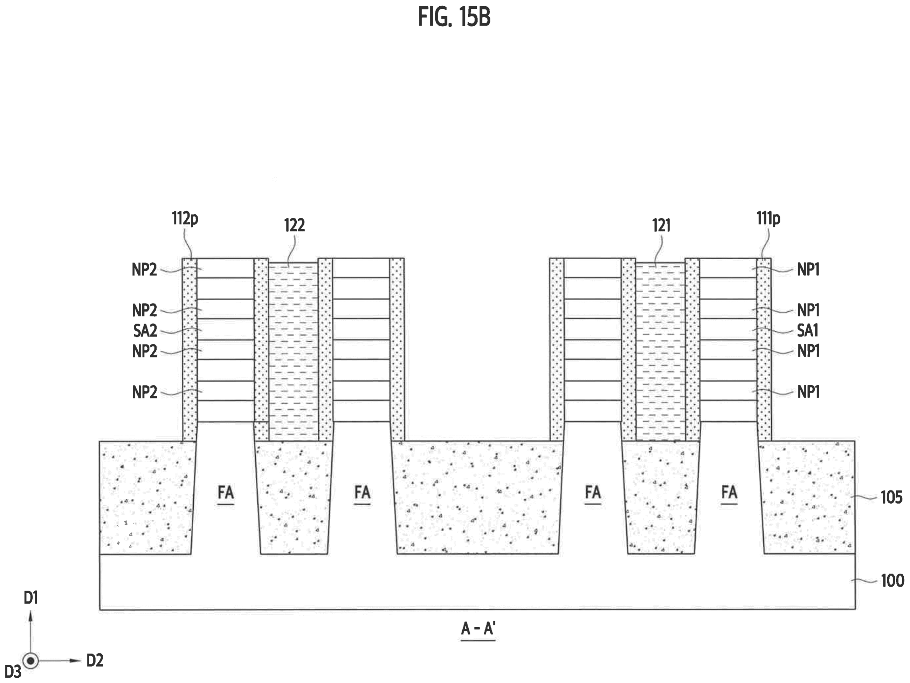

Referring to FIGS. 14A and 15B, the first barrier film 111p which covers both side walls of each of the plurality of first nano-patterns NP1 and both side walls of each of the plurality of first sacrificial films SA1 may be formed. In some implementations, the second barrier film 112p which covers both side walls of each of the plurality of second nano-patterns NP2 and both side walls of each of the plurality of second sacrificial films SA2 may be formed.

According to an example implementation, to begin with, a material layer that covers an upper surface of the device separator 105, side walls of the plurality of sacrificial films SA1 and SA2, side walls of the plurality of nano-patterns NP1 and NP2, and upper surfaces of uppermost nano-patterns NP1 and NP2 may be deposited in order to form the first barrier film 111p and the second barrier film 112p. Afterward, a portion of the material layer, which covers the upper surfaces of the nano-patterns NP1 and NP2, may be removed through an etch-back process, so that the upper surfaces of the uppermost nano-patterns NP1 and NP2 may be exposed. Through the above-described series of processes, the first barrier film 111p covering side walls of the plurality of first sacrificial films SA1 and side walls of the plurality of first nano-patterns NP1 and the second barrier film 112p covering side walls of the plurality of second sacrificial films SA2 and side walls of the plurality of second nano-patterns NP2 may be formed.

According to an example implementation, a plurality of first barrier films 111p may be provided. Each of the plurality of first barrier films 111p may be elongated along the third direction D3 to cover side walls of a first sacrificial film SA1 and a first nano-pattern NP1 alternately arranged along the first direction D1. A plurality of second barrier films 112p may be provided. Each of the plurality of second barrier films 112p may be elongated along the third direction D3 to cover side walls of a second sacrificial film SA2 and a second nano-pattern NP2 alternately arranged along the first direction D1.

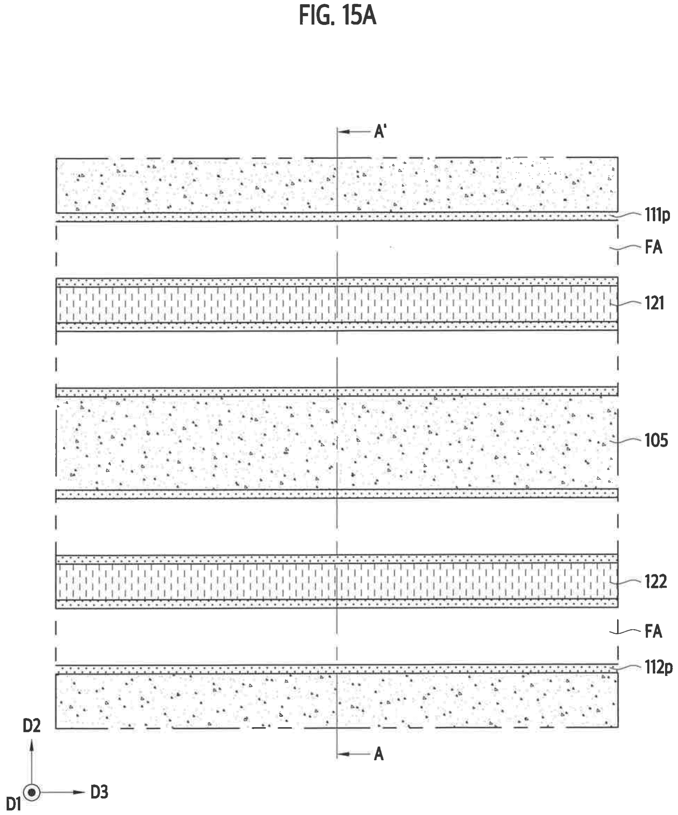

Referring to FIG. 15A and 15B, the first insulation partition 121 may be formed in a space between the plurality of first nano-patterns NP1 which is spaced apart along the second direction D2, and the second insulation partition 122 may be formed in a space between the plurality of second nano-patterns NP2 which is spaced apart along the second direction D2.

According to an example implementation, after an insulation material is deposited in a space between the first barrier films 111p which face each other along the second direction D2, the first insulation partition 121 may be formed when a portion of the insulation material is removed through an etch-back process. Similarly, after an insulation material is deposited in a space between the second barrier films 112p which face each other along the second direction D2, the second insulation partition 122 may be formed when a portion of the insulation material is removed through an etch-back process.

According to an example implementation, a level of an uppermost portion of the formed first insulation partition 121, which is along the first direction D1, may be positioned to be lower than or equal to a level of an uppermost portion of an uppermost first nano-pattern NP1, which is along the first direction D1. Similarly, a level of an uppermost portion of the formed second insulation partition 122, which is along the first direction D1, may be positioned to be lower than or equal to a level of an uppermost portion of an uppermost second nano-pattern NP2, which is along the first direction D1.

Referring to FIGS. 16A and 16B, the insulation material layer 131p may be formed to a product of FIGS. 15A and 15B thereafter. An insulation material may be deposited to cover the upper surface of the device separator 105, an outer side wall and an upper surface of the first barrier film 111p, an outer side wall and an upper surface of the second barrier film 112p, upper surfaces of uppermost first nanosheets NS11 to NS13, upper surfaces of uppermost second nanosheets NS21 to NS23, an upper surface of the first insulation partition 121, and an upper surface of the second insulation partition 122, so that the insulation material layer 131p may be formed.

According to an example implementation, a second insulation material forming the insulation material layer 131p may be different from a first insulation material forming the first barrier film 111p and the second barrier film 112p. As illustrated in FIG. 16A, the insulation material layer 131p may be deposited to cover the product of FIGS. 15A and 15B overall on a plane crossing the first direction D1.

FIG. 16C is a portion of a process in the method of manufacturing the semiconductor device according to another example implementation of the present disclosure. Specifically, FIG. 16C is a portion of a process for manufacturing the semiconductor device 10b illustrated in FIG. 6B.

According to an example implementation, the insulation material layer 131bp may be formed to the product of FIGS. 15A and 15B. At this point, unlike a case of the insulation material layer 131p of FIGS. 16A and 16B, a second insulation material forming the insulation material layer 131bp may be identical to the first insulation material forming the first barrier film 111p and the second barrier film 112p.

According to an example implementation, the insulation material layer 131bp illustrated in FIG. 16C also may be deposited to cover the product of FIGS. 15A and 15B overall on a plane crossing the first direction D1 in a way similar to that for the insulation material layer 131p illustrated in FIGS. 16A and 16B.

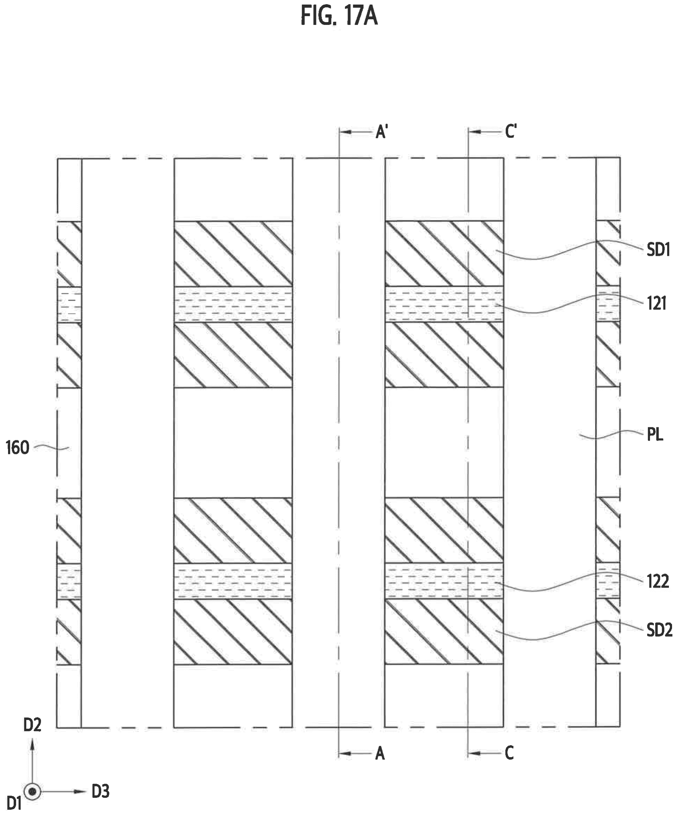

Then, after passing through a series of processes from FIG. 17A to FIG. 21C, the semiconductor device 10b illustrated in FIG. 6B may be completed.

Referring to FIGS. 17A, 17B, and 17C, a plurality of masks PL elongated along the second direction D2 and spaced apart along the third direction D3 may be formed to a product of FIGS. 16A and 16B. The plurality of masks PL may be formed to cover the insulation material layer 131p.

According to an example implementation, after the plurality of masks PL is formed, a portion of the insulation material layer 131p, which is not covered with the mask PL, may be removed through an etch-back process or the like.

According to an example implementation, after the portion of the insulation material layer 131p is removed, a portion of the plurality of nano-patterns NP1 and NP2, a portion of the plurality of sacrificial films SA1 and SA2, and portions of the first barrier film 111p and the second barrier films 112p may be removed through an etching process or the like. At this point, the etching process may be performed so that long patterns extended along the second direction D2 are formed. The etching process may be performed by using selectivity of the mask PL.

According to an example implementation, a portion of the plurality of nano-patterns NP1 and NP2 and a portion of the plurality of sacrificial films SA1 and SA2, which are not covered with the mask PL, may be completely removed. The first barrier film 111p may not be completely removed and may partially remain to cover a side wall of the active area FA. At this point, the remaining first barrier film 111p may become the fifth barrier 115. The second barrier film 112p also may not be completely removed and may partially remain to cover a side wall of the active area FA. At this point, the remaining second barrier film 112p may become the sixth barrier 116.

Afterward, a semiconductor material may be formed in an area, in which the active area FA remains alone as a portion of the plurality of nano-patterns NP1 and NP2 and a portion of the plurality of sacrificial films SA1 and SA2 are removed, and then epitaxially grown, so that the first source/drain area SD1 and the second source/drain area SD2 may be formed. After the first source/drain area SD1 and the second source/drain area SD2 are formed, the inter-layer insulation film 160 in which the first source/drain area SD1 and the second source/drain area SD2 are buried may be formed between the plurality of masks PL which is spaced apart along the third direction D3.

According to an example implementation, as the plurality of masks PL is formed, and as an etching process for forming the first source/drain area SD1 and the second source/drain area SD2 is performed, the first nano-pattern NP1 (see FIG. 16B) and the second nano-pattern NP2 (see FIG. 16B) may be patterned. The first nano-pattern NP1 may be patterned, so that the first nanosheet structure NS1 formed with the plurality of first nanosheet NS11 to NS13 and the first top nanosheet TNS1 may be formed. In some implementations, the third nanosheet structure NS3 (see FIG. 4) formed with the plurality of third nanosheets NS31 to NS33 (see FIG. 4) and the third top nanosheet TNS3 (see FIG. 4), which is spaced apart from the first nanosheet structure NS1, also may be formed. The second nano-pattern NP2 may be patterned, so that the second nanosheet structure NS2 formed with the plurality of second nanosheet NS11 to NS13 and the second top nanosheet TNS2 may be formed. In some implementations, the fourth nanosheet structure NS4 (see FIG. 4) formed with the plurality of fourth nanosheets NS41 to NS43 (see FIG. 4) and the fourth top nanosheet TNS4 (see FIG. 4), which is spaced apart from the second nanosheet structure NS2, also may be formed.

According to an example implementation, a pair of epitaxially grown first source/drain areas SD1 may be spaced apart along the second direction D2 from each other with the first insulation partition 121 in between. At the same time, pairs of first source/drain areas SD1 may be formed to be spaced apart along the third direction D3 with the mask PL in between. According to an example implementation, a pair of epitaxially grown second source/drain areas SD2 may be spaced apart along the second direction D2 from each other with the second insulation partition 122 in between. At the same time, pairs of second source/drain areas SD2 may be formed to be spaced apart along the third direction D3 with the mask PL in between.

According to an example implementation, the first source/drain area SD1 may be positioned to overlap, along the third direction D3, the plurality of first nano-patterns NP1 which is arranged along the first direction D1. The second source/drain area SD2 may be positioned to overlap, along the third direction D3, the plurality of second nano-patterns NP2 which is arranged along the first direction D1.

According to an example implementation, in a process of forming the first source/drain area SD1 and the second source/drain area SD2 through an epitaxial growth process, portions of the first insulation partition 121_a and the second insulation partition 122_a which are exposed may be partially removed. In this process, with respect to the first insulation partition 121 which crosses the first nanosheet structure NS1 and the third nanosheet structure NS3 along the third direction D3 and the second insulation partition 122 which crosses the second nanosheet structure NS2 and the fourth nanosheet structure NS4 along the third direction D3, portions thereof may not be removed as being covered with the mask PL and the insulation material layer 131p and not being exposed.

According to an example implementation, depending on whether such removal in the epitaxial growth process is performed, heights of insulation partitions 121_a and 122_a between source/drain areas SD1 and SD2, which are along the first direction D1, and heights of insulation partitions 121 and 122 crossing the nanosheet structures NS1 to NS4, which are along the first direction D1, may differ.

Referring to FIGS. 18A and 18B, the first hole H1, the second hole H2, and the third hole H3 which penetrate the mask PL along the first direction D1 may be formed to the mask PL. The first hole H1 may be formed to overlap the first insulation partition 121 along the first direction D1. The mask PL may be etched earlier in order to form the first hole H1. Afterward, an etching process may be performed on the insulation material layer 131p which is additionally exposed, and a portion of the insulation material layer 131p may be removed, so that the first insulation film 131 which covers the upper surface of the first insulation partition 121 may be formed.

According to an example implementation, the second hole H2 may be formed to overlap a portion of the device separator 105 between the first insulation partition 121 and the second insulation partition 122. The second hole H2 may be formed not to overlap an insulation partition or a nanosheet. Th mask PL may be etched earlier for forming the second H2, and then, an etching process on a portion of the insulation material layer 131p which is additionally exposed may be performed. When an etching process for the mask PL and a portion of the insulation material layer 131p is finished, the second hole H2 which is formed to expose the insulation material layer 131p may be completed.

According to an example implementation, the third hole H3 may be formed in a scheme identical to a scheme of forming the first hole H1. An etching process may be performed on the insulation material layer 131p in a process of forming the third hole H3, a portion of the insulation material layer 131p may be removed, and the second insulation film 132 which covers the upper surface of the first insulation partition 121 may be formed.

Referring to FIGS. 19A and 19B, an insulation material may be deposited in the first hole H1, so that the first upper insulation partition 141 may be formed. An insulation material may be deposited in the third hole H3, so that the second upper insulation partition 142 may be formed. Also, an insulation material may be deposited in the second hole H2, so that the field insulation partition 151 may be formed. According to an example implementation, insulation materials deposited to form the first upper insulation partition 141, the second upper insulation partition 142, and the field insulation partition 151 may be identical to an insulation material forming the first insulation partition 121 and the second insulation partition 122.

FIG. 19C is a portion of a process in the method of manufacturing the semiconductor device according to another example implementation of the present disclosure. Specifically, FIG. 19C is a part of a process for manufacturing the semiconductor device 40 illustrated in FIG. 10.

Referring to FIG. 19C, an insulation material may be deposited in the first hole H1, so that the first upper insulation partition 441 may be formed. An insulation material may be deposited in the third hole H3, so that a second upper insulation partition may be formed. Also, an insulation material may be deposited in the second hole H2, so that the field insulation partition 451 may be formed. According to an example implementation, insulation materials deposited to form the first upper insulation partition 441, the second upper insulation partition, and the field insulation partition 451 may be different from the insulation material forming the first insulation partition 121 and the second insulation partition 122.

Referring to FIGS. 20A and 20B, the masks PL which surround first and second nanosheet structures NS1 and NS2 and third and fourth nanosheet structures NS3 and NS4 may be removed. Afterward, an insulation material may be deposited, so that the first interface layer IL1 which surrounds the plurality of first nanosheets NS11 to NS13 and the first top interface layer TIL1 which surrounds the first top nanosheet TNS1 may be formed. In some implementations, an insulation material may be deposited, so that the second interface layer IL2 which surrounds the plurality of second nanosheets NS21 to NS23 and the second top interface layer TIL2 which surrounds the second top nanosheet TNS2 may be formed.

Then, the plurality of first barriers 111 and the plurality of second barriers 112 may be formed through etching processes on the first barrier film 111p and the second barrier film 112p. Portions of the first barrier film 111p and the second barrier film 112p of which side surfaces are not covered with the first nanoseet structure NS1 and the second nanosheet structure NS2 may be removed at a time of the etching processes on the first barrier film 111p and the second barrier film 112p. A portion of the first barrier film 111p, which has been exposed relatively less as having being interposed between the first nanosheet structure NS1 and the first insulation partition 121, may remain, so that the first barrier 111 may be formed. Similarly, a portion of the second barrier film 112p, which has been exposed relatively less as having being interposed between the second nanosheet structure NS2 and the second insulation partition 122, may remain, so that the second barrier 112 may be formed.

In a scheme identical to a process of forming the plurality of first barriers 111 and the plurality of second barriers 112, the plurality of third barriers 113 (see FIG. 4) which is interposed between the third nanosheet structure NS3 (see FIG. 4) and the first insulation partition 121 and the plurality of fourth barriers 114 (see FIG. 4) which is interposed between the fourth nanosheet structure NS4 (see FIG. 4) and the second insulation partition 122 may be formed.

According to an example implementation, when the etching processes on the first barrier film 111p and the second barrier film 112p are excessively formed, the first barrier film 111p between the first nanosheet structure NS1 and the first insulation partition 121 and the second barrier film 112p between the second nanosheet structure NS2 and the second insulation partition 122 may be completely removed. In such a case, when a subsequent process to be described below is performed, all four surfaces of each of the plurality of first nanosheets NS11 to NS13 and the plurality of second nanosheets NS21 to NS23 may be surrounded by the interface layer IL1, IL2, IL3, or IL4 and the insulation liner HK.

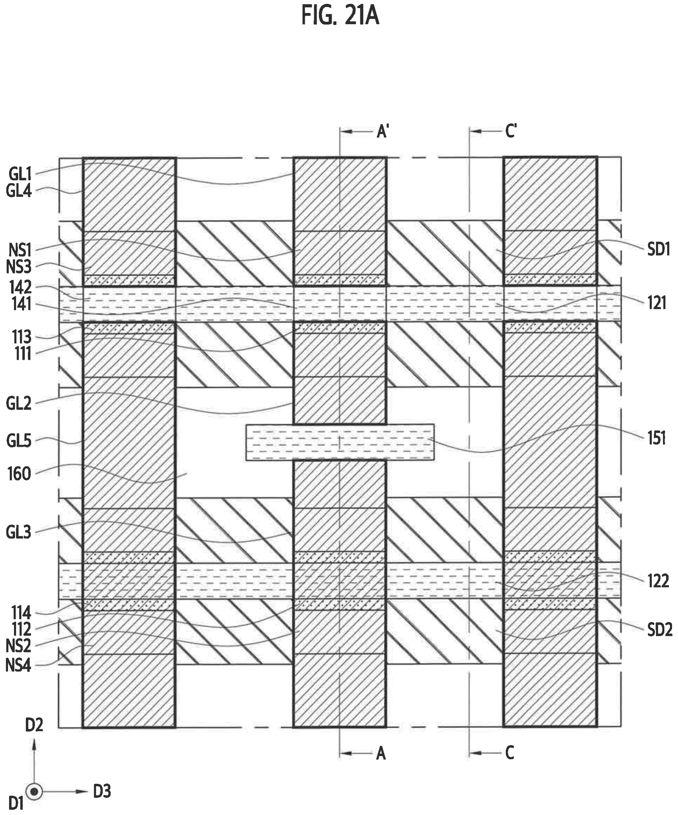

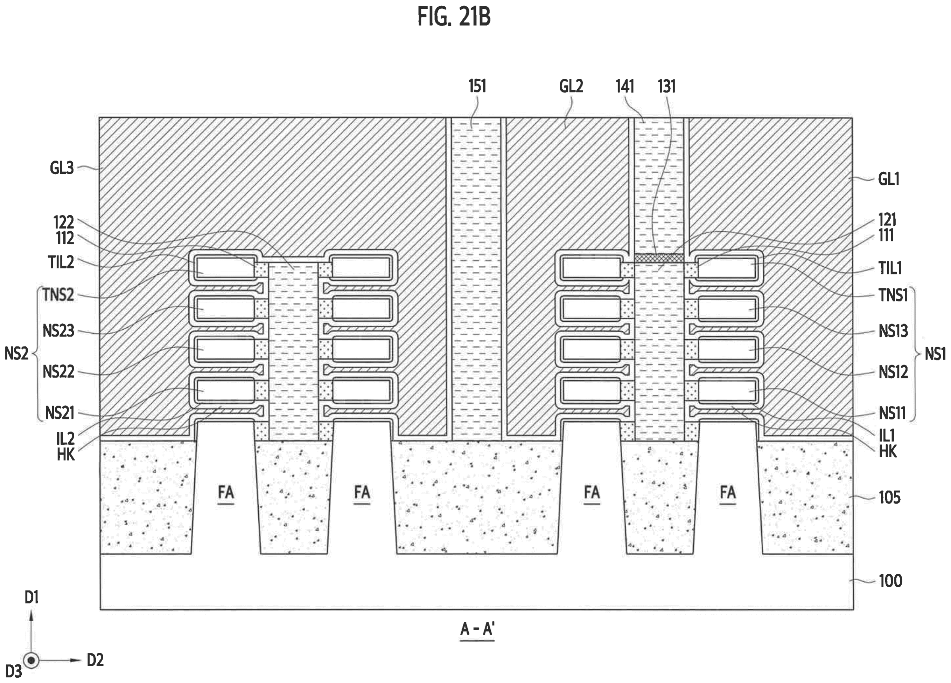

Referring to FIGS. 21A and 21B, the insulation liner HK which covers the upper surface of the deviec separator 105, the first nanosheet structure NS1, the second nanosheet structure NS2, the first to sixth barriers 111 to 116, first and second insulation partitions 121 and 122, first and second upper insulation partitions 141 and 142, and the field insulation partition 151 may be formed. An atomic layer deposition (ALD) process may be used in order to form the insulation liner HK.

Then, a plurality of gate lines GL to GL5 may be formed by filling a space on the insulation liner HK above the plurality of nanosheet structures NS1 to NS4. The first gate line GL1 which is positioned at a side of the first upper insulation partition 141 and surrounds some of the plurality of first nanosheets NS11 to NS13 arranged along the first direction D1 and some of the first top nanosheets TNS1 may be formed. Also, the second gate line GL2 which surrounds, at another side opposite to the side of the first upper insulation partition 141 (for example, between the first insulation partition 121 and the field insulation partition 151), another of the plurality of first nanosheets NS11 to NS13 arranged along the first direction D1 and another of the first top nanosheets TNS1 may be formed. In some implementations, the third gate line GL3 which surrounds the second nanosheet structure NS2 at a side of the field insulation partition 151 may be formed.

The fourth gate line GL4 which is positioned at a side of the second upper insulation partition 142 and surrounds some of the plurality of third nanosheets NS31 to NS33 arranged along the first direction D1 and some of the third top nanosheets TNS3 may be formed. Also, the fifth gate line GL5 which surrounds, at another side opposite to the side of the second upper insulation partition 142, another of the plurality of third nanosheets NS31 to NS33 arranged along the first direction D1 and another of the third top nanosheets TNS3 may be formed.

Furthermore, the inter-layer insulation film 160 may be formed above the pair of first source/drain areas SD1 and the pair of second source/drain areas SD2. The semiconductor device 10 illustrated in FIGS. 1 through 5 may be completed through the above-described series of processes.

According to still another aspect, there is also provided a method of manufacturing a semiconductor device, the method including forming, on a substrate, a plurality of sacrificial films and a plurality of nano-patterns that are alternately stacked along a first direction crossing a surface of the substrate and spaced apart along a second direction crossing the first direction, forming a plurality of barrier films configured to cover both side walls of the plurality of sacrificial films and both side walls of the plurality of nano-patterns, forming an insulation partition by depositing an insulation material in a space between the plurality of sacrificial films and the plurality of nano-patterns spaced apart along the second direction, forming an insulation material layer configured to cover an upper surface of the insulation partition, forming a mask that surrounds the insulation material layer and to which a first hole is formed to, and forming an upper insulation partition by depositing an insulation material in the first hole.

A level of an uppermost portion of the insulation partition, which is along the first direction, may be lower than a level of an uppermost portion of an uppermost nano-pattern, which is along the first direction, among the plurality of nano-patterns.

The upper insulation partition and the insulation partition may be formed of an identical insulation material.

The upper insulation partition and the insulation partition may be formed of different insulation materials.

The plurality of barrier films and the insulation material layer may be formed of different materials.

An uppermost surface of the insulation partition may be concavely formed.

In the forming of the mask, a second hole that is spaced apart from the first hole along the second direction and of which a length along the first direction is longer than that of the first hole may be formed to the mask.

The method may further include forming, by depositing an insulation material in the second hole, a field insulation partition of which a length along the first direction is longer than that of the upper insulation partition.

As used herein, "approximately," and "substantially" are understood to refer to numbers in a range of numerals, for example the range of -10% to +10% of the referenced number, preferably -5% to +5% of the referenced number, more preferably -1% to +1% of the referenced number, most preferably -0.1% to +0.1% of the referenced number. Moreover, any numerical ranges disclosed herein should be interpreted as providing support for any specific value or sub-range within the stated range. For example, a disclosure of a range from 1 to 10 supports sub-ranges such as 1 to 5, 3 to 6, 1 to 9, 2.5 to 4.7, 2.2 to 9.9, and so on.

While the present disclosure contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a substrate (100);
an insulation partition (121) extended along a first direction (D1) crossing a surface of the substrate (100); and
a plurality of sheets (NS11, NS12, NS13, TNS1) spaced apart along a second direction (D2) crossing the first direction (D1) with the insulation partition (121) in between and arranged side by side along the first direction (D1) above the substrate (100),
wherein the plurality of sheets (NS11, NS12, NS13, TNS1) comprise a top sheet (TNS1) positioned at a highest level along the first direction (D1), and
wherein a first uppermost portion of the insulation partition (121) between the plurality of sheets (NS11, NS12, NS13, TNS1) is positioned at a level (LV1) lower than or equal to an uppermost portion of the top sheet (TNS1) in the first direction (D1).

2. The semiconductor device of claim 1, comprising a pair of first source/drain areas (SD1) adjacent to the plurality of sheets (NS11, NS12, NS13, TNS1) along a third direction (D3) crossing the first direction (D1) and the second direction (D2),
wherein the insulation partition (121) extends between the pair of first source/drain areas (SD1), and
wherein, with respect to the first direction (D1), a second uppermost portion of the insulation partition (121) between the pair of the first source/drain areas (SD1) is positioned at a level lower than the first uppermost portion of the insulation partition (121) between the plurality of sheets (NS11, NS12, NS13, TNS1).

3. The semiconductor device of claim 1 or 2, comprising:
a barrier (111) interposed between the insulation partition (121) and each of the plurality of sheets (NS11, NS12, NS13, TNS1);
an upper insulation partition (141) spaced apart from the insulation partition (121) along the first direction (D1); and
an insulation film (131) between the upper insulation partition (141) and the insulation partition (121).

4. The semiconductor device of claim 3, wherein a material of the barrier (111) is different from a material of the insulation film (131).

5. The semiconductor device of claim 4, comprising a material layer (1311a) between the upper insulation partition (141) and the insulation film (131),
wherein the material of the barrier (111) is different from a material of the material layer (1311a).

6. The semiconductor device of claim 3, wherein a material of the barrier (111) is a same as a material of the insulation film (131).

7. The semiconductor device of claim 6, comprising an insulation liner (HK) being disposed outside a periphery of the insulation partition (121),
wherein the insulation liner (HK) is interposed between the insulation partition (121) and the upper insulation partition (141), and the insulating liner (HK) is in contact with a side surface of the insulation film (131).

8. The semiconductor device of any one of claims 1 to 7, comprising:
a pair of active areas (FA) protruding from the substrate (100) in the first direction (D1); and
a device separator (105) between the pair of active areas (FA),
wherein the insulation partition (121) is in contact with the device separator (105).

9. The semiconductor device of claim 1, comprising:
a pair of active areas (FA) protruding from the substrate (100) in the first direction (D1) and spaced apart along the second direction (D2);
a first nanosheet structure (NS1) comprising the plurality of sheets (NS11, NS12, NS13, TNS1) arranged side by side along the first direction (D1) from the pair of active areas (FA), wherein the sheets (NS11, NS12, NS13, TNS1) are first nanosheets and the top sheet (TNS1) is a first top nanosheet;
an upper insulation partition (142) above an uppermost surface of the insulation partition (121), wherein the uppermost surface of the insulation partition (121) crosses the first direction (D1); and
a field insulation partition (151) spaced apart from the insulation partition (121) along the second direction (D2), wherein a portion of the plurality of sheets (NS11, NS12, NS13, TNS1) is between the field insulation partition (151) and the insulation partition (121),
wherein the insulation partition (121) extends along a third direction (D3) crossing the first direction (D1) and the second direction (D2), and
wherein an uppermost portion of the uppermost surface (121_s) of the insulation partition (121) along the first direction (D1) is positioned at a level lower than an uppermost portion of an uppermost surface (TNS1_s) of the top sheet (TNS1), wherein the uppermost surface (TNS1_s) of the top sheet (TNS1) crosses the first direction (D1).

10. The semiconductor device of claim 9, wherein an uppermost portion of the field insulation partition (151) along the first direction (D1) is positioned at a level higher than the uppermost portion of the uppermost surface (TNS1_s) of the top sheet (TNS1).

11. The semiconductor device of claim 9 or 10, wherein a length of the field insulation partition (151) along the first direction (D1) is longer than a length of the insulation partition (121) along the first direction (D1).

12. The semiconductor device of any one of claims 9 to 11, comprising an insulation liner (HK), wherein the insulation liner (HK), in a cross section crossing the third direction (D3), is disposed outside a periphery of four surfaces of each of the plurality of sheets (NS11, NS12, NS13, TNS1), wherein each of the plurality of sheets (NS11, NS12, NS13, TNS1) has a quadrangular shape in a cross-section taken along a plane defined by the first direction (D1) and the second direction (D2).

13. The semiconductor device of any one of claims 9 to 12, wherein at a same level along the first direction (D1), a width of the field insulation partition (151) along the second direction (D2) is different from a width of the upper insulation partition (141) along the second direction (D2).

14. The semiconductor device of any one of claims 9 to 13, wherein a material of the insulation partition (121) is different from a material of the upper insulation partition (142).

15. The semiconductor device of any one of claims 9 to 14, comprising:
an insulation film (131) interposed between the insulation partition (121) and the upper insulation partition (141);
a second nanosheet structure (NS2) comprising a plurality of second nanosheets (NS21, NS22, NS23, TNS2) spaced apart from the first nanosheet structure (NS1) along the second direction (D2) and arranged side by side along the first direction (D1), wherein the field insulation partition (151) is between the first nanosheet structure (NS1) and the second nanosheet structure (NS2);
a first gate line (GL1) being disposed outside a periphery of a first portion of the plurality of first nanosheets (NS11, NS12, NS13, TNS1), wherein the portion of the plurality of first nanosheets (NS11, NS12, NS13, TNS1) is at a first side of the upper insulation partition (142);
a second gate line (GL2) being disposed outside a periphery of a second portion of the plurality of first nanosheets (NS11, NS12, NS13, TNS1), wherein the second portion of the plurality of first nanosheets (NS11, NS12, NS13, TNS1) is at a second side opposite to the first side of the upper insulation partition (141); and
a third gate line (GL3) spaced apart from the second gate line (GL2) along the second direction (D2) and being disposed outside a periphery of the plurality of second nanosheets (NS21, NS22, NS23, TNS2), wherein the field insulation partition (151) is between the second gate line (GL2) and the third gate line (GL3).
